Europäisches Patentamt

European Patent Office

Office européen des brevets

(11) Publication number: **0 616 241 A2**

## EUROPEAN PATENT APPLICATION

(21) Application number: **94104225.1**

(22) Date of filing: **17.03.94**

(51) Int. Cl.5: **G02F 1/136**, B23K 26/14,
H01L 21/00, H01L 21/311,
H01L 21/321, H01L 21/84,
H01L 27/12, G03F 7/20,
H01L 21/336

(30) Priority: **17.03.93 JP 56726/93**

(43) Date of publication of application:
**21.09.94 Bulletin 94/38**

(84) Designated Contracting States:
**DE FR GB**

(71) Applicant: **HITACHI, LTD.**
**6, Kanda Surugadai 4-chome**
**Chiyoda-ku, Tokyo 101 (JP)**

(72) Inventor: **Suzuki, Kenkichi**
**3713-3 Hayano Mobara-shi**
**Chiba-ken (JP)**

(74) Representative: **Patentanwälte Beetz - Timpe -**
**Siegfried Schmitt-Fumian - Mayr**
**Steinsdorfstrasse 10**
**D-80538 München (DE)**

(54) **A method of manufacturing a liquid crystal display device with excimer laser.**

(57) A pattern of mask is formed on the surface of a transparent insulating substrate by means of an optical system that uses an excimer layer as a light source. By the interaction between light and film material, the film material struck by light is removed and dispersed in the form of gases or fine particles, thus forming the gate lines and gate terminals of thin-film transistors.

EP 0 616 241 A2

## BACKGROUND OF THE INVENTION

The present invention relates to a method and an apparatus for producing thin-film transistors and more particularly of liquid crystal display devices of active matrix type using thin film transistors (TFTs) or the like.

In a liquid crystal display device of active matrix type, non-linear devices (e.g., switching devices) are disposed in a manner to correspond to a plurality of pixel electrodes arranged in matrix, respectively. The liquid crystal in each pixel is always drive, in principle, (at a duty ratio of 1.0). In comparison with the so-called "simple matrix type" which employs a time division driving system, therefore, the active system has better contrast and has become an indispensable technique particularly in a color liquid crystal display device. A typical example of the switching devices is a thin film transistor (TFT).

Here, the liquid crystal display device of active matrix type using the thin film transistors is known in Japanese Patent Laid-Open No. 309921/1988 or on pp. 193 to 210 of Nikkei Electronics entitled "Active Matrix Type Color Liquid Crystal Display of 12.5 Type Adopting Redundant Construction" and issued on December 15, 1986 by NIKKEI McGRAW-HILL, for example.

Patterns of layers in a conventional TFT substrate, as described in the above-mentioned publication, are formed by photolithography, a technique commonly used in semiconductor device fabrication which consists of a series of processes including resist coating, baking, exposure, development, etching, resist removal and cleaning.

Since the excimer laser was first made public in 1982, many studies have been conducted on its application to the manufacturing processes. Example applications of the excimer laser include marking glasses and ceramics and processing polymer films and ceramic and glass materials. There are many publications concerning the excimer laser, but as far as the inventors know, no published literatures exist that explicitly describe the application of the excimer to the patterning of thin-film transistor arrays and liquid crystal display panels.

As mentioned above, because the conventional TFT liquid crystal display panel requires a large-scale facility and because the display panel requires a large substrate, the manufacturing cost far exceeds that of a cathode ray tube. To promote spread of the liquid crystal display panels, cost reduction is essential. The approach for promoting an increased use has generally been directed to improving the cleanliness of manufacturing environment, reducing the number of photolithography processes, and development of defect correcting technology. There are, however, few publications that focus attention on an effort to eliminate the series of photo processes themselves, which occupy a major part of the semiconductor manufacturing process.

The present invention, if viewed only from the result, may give an impression that it can be accomplished easily. If the background mentioned above is correctly evaluated, it will be understood that this is an invention that has surpassed the conventional fixed notion and offers epoch-making and unfathomable effects.

## SUMMARY OF THE INVENTION

The above-mentioned conventional technique has the following drawbacks.

1. It requires many manufacturing facilities in the series of processes. The operation of these facilities requires a clean room and associated facilities. These facilities become greater in size as the substrate becomes large and the production output increases.

2. The conventional technique requires such materials as resist, developing liquid, etching liquid and separation liquid. In addition, disposal and treatment of these used liquids to make them environmentally non-polluting proves expensive.

3. In the pattern formation in each layer, there is a high possibility that debris and contaminations will remain because the substrate surface comes into contact with resist and treating liquids. For high yields, a cleaning process must be introduced, prolonging the processing time and necessitating plant investment.

An objective of this invention is to provide a method of manufacturing thin-film transistors, which can significantly reduce the cost of manufacturing facilities and materials used by reducing the number of conventional photolithography processes.

Another objective of this invention is to provide a method of manufacturing thin-film transistors, which is effective for prevention of environmental pollution.

A further objective of this invention is to provide a method of manufacturing thin-film transistors, which can reduce residues and contaminations that occur during pattern formation and improve yield.

A further objective of this invention is to provide a method of manufacturing thin-film transistors, whose process is shortened. A further object is to provide an apparatus for carrying out the method.

The above objects are achieved according to the independent claims. The dependent claims relate to preferred embodiments.

According to one embodiment of this invention, there is provided a method of manufacturing thin-film transistors, by which an optical system using an excimer laser as a light source forms a pattern on the surface of a transparent insulating substrate to be processed to remove the film material where light strikes and release it in the form of gases or fine particles by the mutual interaction between light and the film material, thus forming gate circuits and gate terminals.

Because the mask pattern transfer and the processing of films can be carried out simultaneously, the method of this invention substantially reduces the number of processes, the size of required facility and the turn-around time when compared with the conventional photolithography, which includes resist coating, baking, exposure, development and exposure, development, etching, resist separation and cleaning. This in turn results in significant reduction in the fabrication cost, and also realizes improved yield and reliability because no etching or cleaning residues remain.

BRIEF DESCRIPTION OF THE DRAWINGS

Fig. 1 is a schematic diagram of an excimer laser apparatus to explain the working principle of this invention;

Fig. 2 is a plan view of an essential portion of the first embodiment of this invention, showing one pixel and associated circuits on a liquid crystal display section of a color liquid crystal display device of active matrix type;

Fig. 3 is a section taken along line 3 - 3 of Fig. 2 and shows one pixel and its peripheral portion;

Fig. 4 is a section taken along line 4 - 4 of Fig. 2 and shows an additional capacitor Cadd;

Fig. 5 is a top plan view for explaining the construction a matrix peripheral portion of a display panel;

Fig. 6 is a panel top plan view for exaggerating and explaining the peripheral portion of Fig. 5 more specifically;

Fig. 7 is an enlarged top plan view showing a corner of a display panel including an electric connection portion of upper and lower substrates;

Fig. 8 is a section showing the pixel portion of a matrix at the center and the vicinity of a panel corner and the vicinity of a video signal terminal portion at the two sides;

Fig. 9 is a section showing panel edge portions with and without a scanning signal terminal at the lefthand and righthand sides;

Fig. 10 presents a top plan view and a section showing the vicinity of a connecting portion between a gate terminal GTM and a gate signal line GL;

Fig. 11 presents a top plan view and a section showing the vicinity of a connecting portion between a gate terminal GTM and a gate signal line DL;

Fig. 12 is an equivalent circuit diagram showing a liquid crystal display circuit of a color liquid crystal display device of active matrix type;

Fig. 13 presents a flow chart of sections of a pixel portion and a gate terminal portion and shows the fabrication steps A to C at the side of a substrate SUB1;

Fig. 14 presents flow chart of sections of the pixel portion and the gate terminal portion and shows the fabrication steps D to F at the side of the substrate SUB1;

Fig. 15 presents a flow chart of sections of the pixel portion and the gate terminal portion and shows the fabrication steps G to I at the side of the substrate SUB1;

Fig. 16 is an exploded perspective view showing a li - quid crystal display module;

Fig. 17 is a upper side view showing the state, in which peripheral drive circuits are packaged in the liquid crystal display panel;

Fig. 18 is a section showing a structure of a tape carrier package TCP, in which an integrated circuit chip CHI constituting a drive circuit is mounted on a flexible wiring substrate;

Fig. 19 is a section showing the state of an essential portion, in which the tape carrier package TCP is connected with a video signal circuit terminal DTP of a liquid crystal display panel PNL;

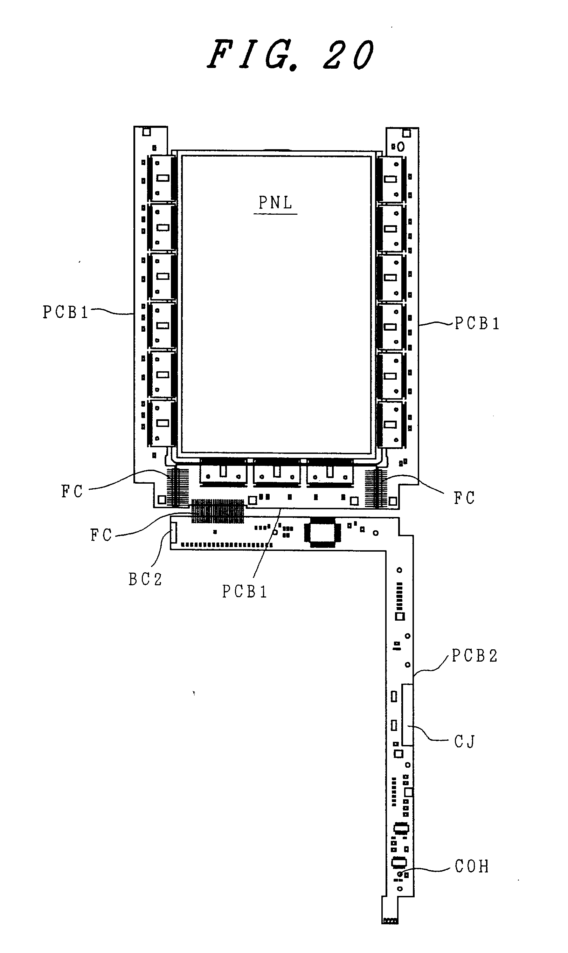

Fig. 20 is an upper side view showing the connection state between the peripheral drive circuit substrate (as viewed from the upper side) of the liquid crystal display and the drive circuit substrate (as viewed from the lower side) to be mounted on the middle frame;

Fig. 21 is a plan view of a mask pattern used for excimer laser processing;

Fig. 22 is a schematic diagram showing an excimer laser patterning apparatus according to this invention;

Fig. 23 is a cross-sectional process flow representing a second embodiment of this invention;

Fig. 24 is a cross-sectional process flow representing a second embodiment of this invention;

Fig. 25 is a cross-sectional process flow representing a second embodiment of this invention;

Fig. 26 is a cross section showing a thin-film transistor of third to sixth embodiment of this invention; and

Fig. 27 is a cross-sectional process flow representing third to sixth embodiment of this invention.

## DESCRIPTION OF PREFERRED EMBODIMENTS

The present invention, other objects of the present invention, and other features of the present invention will become apparent from the following description to be made with reference to the accompanying drawings.

In the following embodiments, the excimer laser is defined as a kind of gas laser which uses as a laser medium a noble gas and a halogen donor, that produces a compound only in the excited state. The excimer laser oscillates in the ultraviolet range of spectrum and the wavelength of the ultraviolet ray produced is 157, 193, 222, 248, 308, and 351 nm when the noble gas is $F_2$, ArF, KrCl, KrF, XeCl, and XeF, respectively. Because the excimer laser can offer a beam whose wavelength is one or two orders of magnitude shorter than those produced by general $CO_2$ and YAG lasers, it is suited for fine processing.

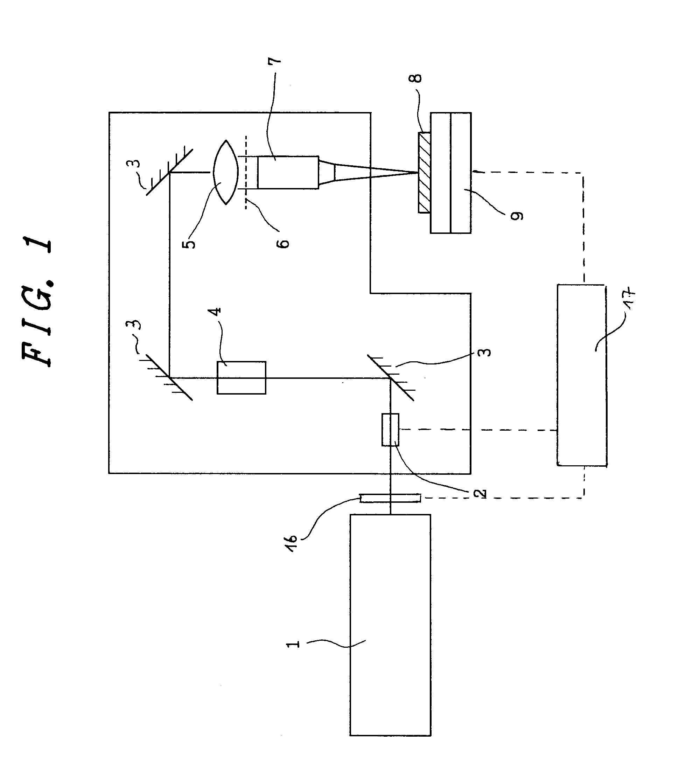

Figure 1 shows an apparatus and the working principle of this invention.

The apparatus comprises an excimer laser 1. The laser beam first passes through a shutter 16, an attenuator 2 and a homogenizer 4. The laser beam is suitably deflected by means of mirrors 3. The apparatus further comprises an image forming system consisting of a field lens 5 and an image lens 7. A pattern forming mask 6 is arranged between the field lens 5 and the image lens 7.

The optical system 5, 7 transfers the pattern of the mask 6 onto the surface of an insulating substrate 8 or of an intermediate product of the manufacturing process comprising that substrate 8. The substrate or intermediate product is mounted on an X-Y stage 9. The apparatus further comprises means 17 for controlling the X-Y stage in accordance with a predetermined program correlated to the pattern of the mask 6. The shutter 16 is preferably controlled in correspondence with the movement steps of the X-Y stage 9, preferably by the means 17 for controlling the X-Y stage 9. The means 17 may also control the attenuator 2.

The device may comprise more than one excimer laser for being adapted to carry out several kinds of selective irradiation (wavelength, energy density, etc.).

The substrate 8 (SUB1) is preferably an insulating transparent glass substrate (TFT substrate) on which a thin-film transistor array for a liquid crystal display device is to be formed.

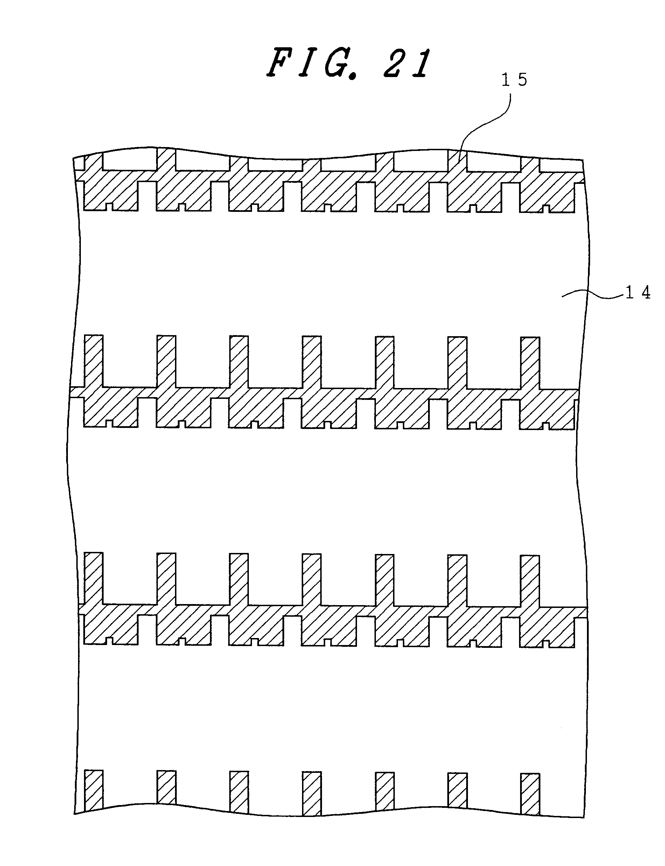

Figure 21 schematically shows the transferred pattern. In areas 14 where light strikes the surface film of the substrate 8, the interaction between light and the film material breaks the molecular bonds of the solid material, dispersing it in the form of gases or fine particles, whereas the hatched, unexposed areas 15 remain as they are. In this way, a desired pattern is formed on the film. The pattern precision and resolution depend on the image forming optical system shown in Figure 1 whose working principle is similar to ordinary reducing projection exposing equipment.

The TFT substrate, as described later, has pixels arranged thereon in a regular, cyclic matrix form. So, the mask 6 does not include all the patterns for the entire substrate but only a number of patterns that corresponds to an integer times the vertical and horizontal repetition cycles. The entire pattern on the substrate is formed by moving the X-Y stage 9. This principle is quite the same as the mechanism of the stepper type exposing apparatus. As described later, because the pattern of pixel section and the pattern of terminal section differ, the excimer laser processing apparatus is provided with a mechanism for changing the mask 6.

The interaction between the excimer laser and the material is non-thermal, and the cross section in the direction of film thickness is often close to right angles. The cross section may be inclined by bringing the pattern image slightly out of focus or increasing the number of exposing shots at relatively low energy concentration.

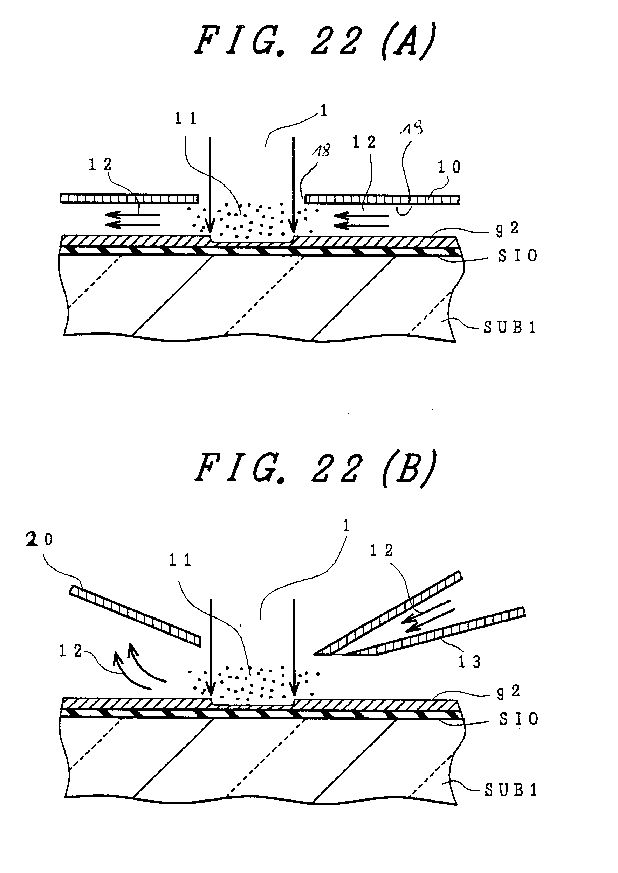

As mentioned above, when the excimer laser emits a beam, the film material becomes dispersed. The dispersed material can be prevented from adhering to the surface being processed by producing a gas flow of normal pressure or of reduced pressure, as shown in Fig. 22. As will be explained later, the device according to Fig. 22(A) uses a laminar flow and that of Fig. 22(B) a nozzle for blowing a gas over the irradiated portion. When an inert gas is used, physical dispersion and heat transfer may be combined in a single mechanism. Oxidizing or reducing gases may be used if the base material is not affected by these gases.

Embodiment 1

Active Matrix Liquid Crystal Display Device

Here will be described in the following the construction of the present invention in connection with embodiments of a color liquid crystal display device of active matrix type, to which is applied the present invention. Incidentally, the parts having identical functions are designated at identical reference characters throughout all the Figures for describing the embodiments, and their repeated descriptions will be omitted.

Summary of Matrix Portion

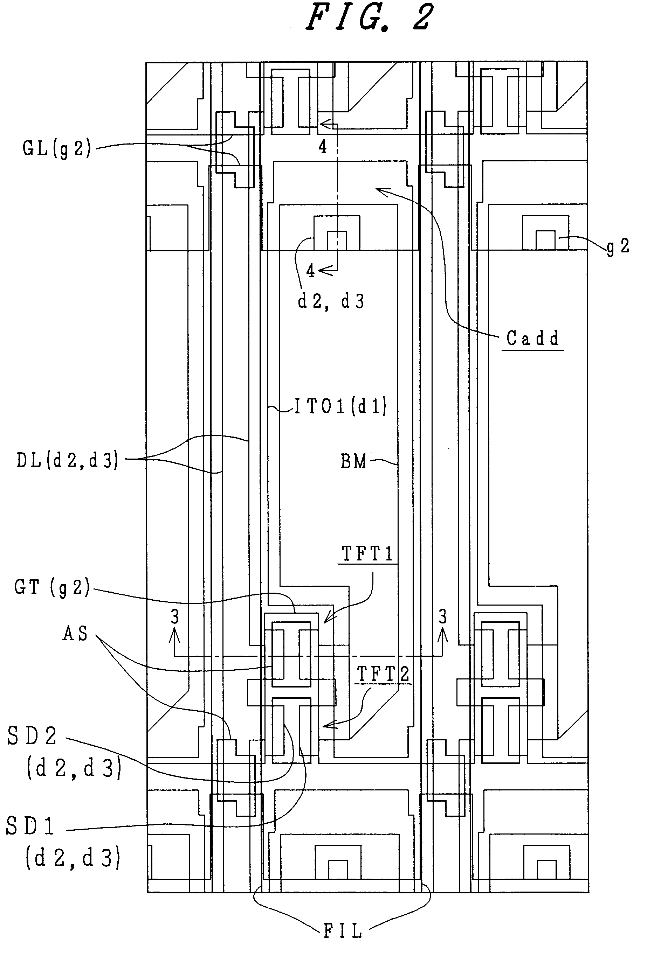

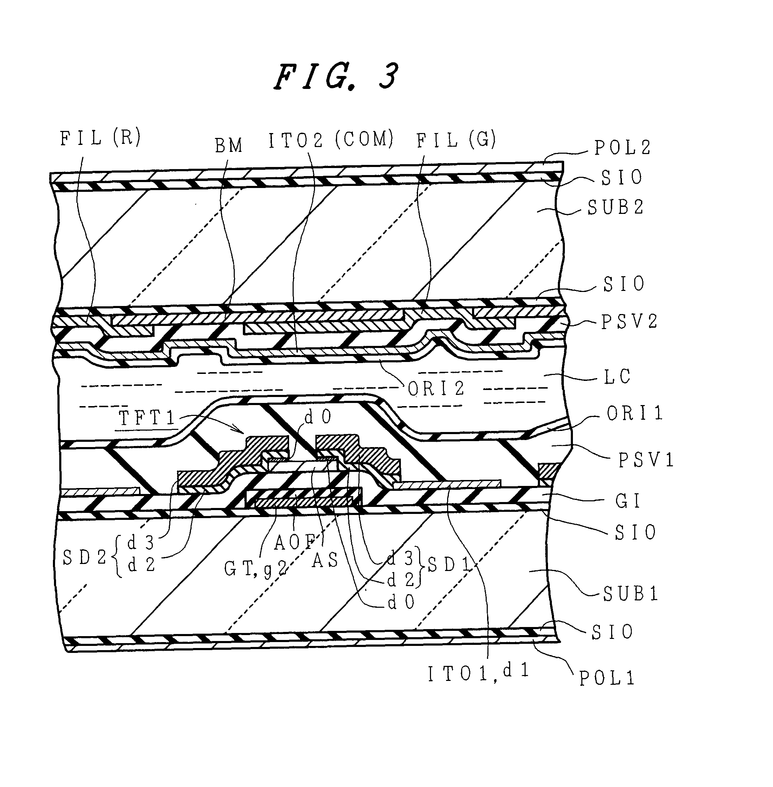

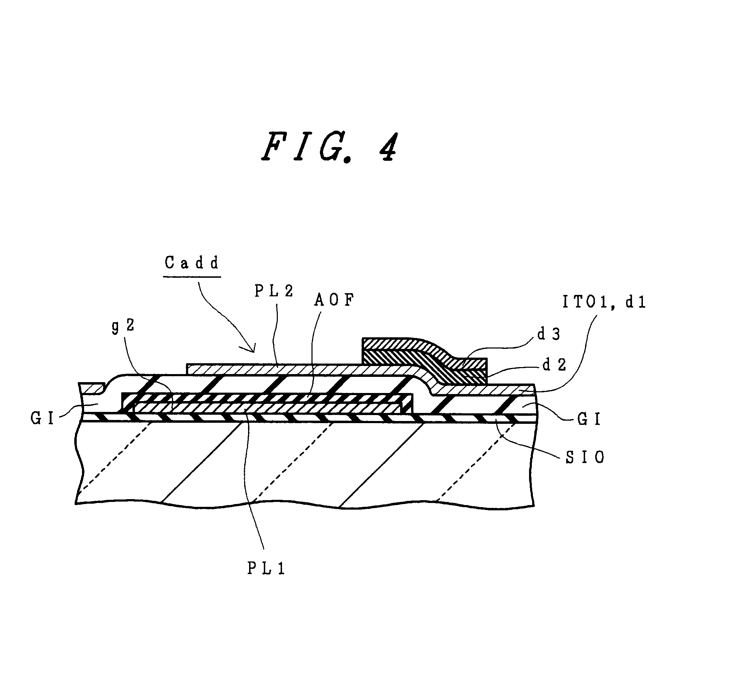

Fig. 2 is a top plan view showing one embodiment of one pixel and its peripheral portion of the active matrix type color liquid crystal display device to which is applied the present invention. Fig. 3 is a section taken along line 3 - 3 of Fig. 2. Fig. 4 is a section taken along line 4 - 4 of Fig. 2.

As shown in Figure 2, each pixel is arranged in a cross region (defined by four signal lines) between two adjacent scanning signal lines (gate signal lines or horizontal signal lines) GL and two adjacent video signal lines (drain signal lines and vertical signal lines) DL. Each pixel includes a thin film transistor TFT, a transparent pixel electrode ITO1, and a latching capacitor Cadd. The scanning signal lines GL extend in the lateral direction and are parallelly arranged in the vertical direction. The video signal lings DL extend in the vertical direction and are parallelly arranged in the lateral direction.

As shown in Fig. 3, the thin film transistor TFT and the transparent pixel electrode ITO1 are formed at the side of a lower transparent glass substrate SUB1 across a liquid crystal layer LC, and a color film FIL and a back matrix pattern BM for light shielding are formed at the side of an upper transparent glass substrate SUB2. The side of the lower transparent glass substrate SUB1 is made to have a thickness of about 1.1 mm, for example. On the both surfaces of the transparent glass substrates SUB1 and SUB2, there are formed silicon oxide layers SIO which are deposited by the dip treatment.

On the surface of the upper transparent glass substrate SUB2 at the inner side (or the side of the liquid crystal LC), there are sequentially laminated the light-shielding film BM, the color filter FIL, a passivation film PSV2, a common transparent pixel electrode ITO2 (or COM) and an upper orientation film ORI2.

A pattern of the matrix section on the substrate SUB1 side is formed as follows. In the case of a display panel of $640 \times 400$ pixels, for example, a 128-pixel-in-row-by-100-pixel-in-column mask is used and moved in a total of 20 steps, i.e. in 5 steps in lateral direction and 4 steps in vertical direction, relative to the excimer laser while emitting beams. Figure 21 shows a part of the mask for the matrix section. The mask pattern is transferred onto a layer g2 for the gate electrodes GT and the gate lines GL shown in Figure 2. The hatched areas 2 represent portions where the laser beam is not transmitted, i.e. the portions where the layer g2 will remain.

Summary of Matrix Periphery

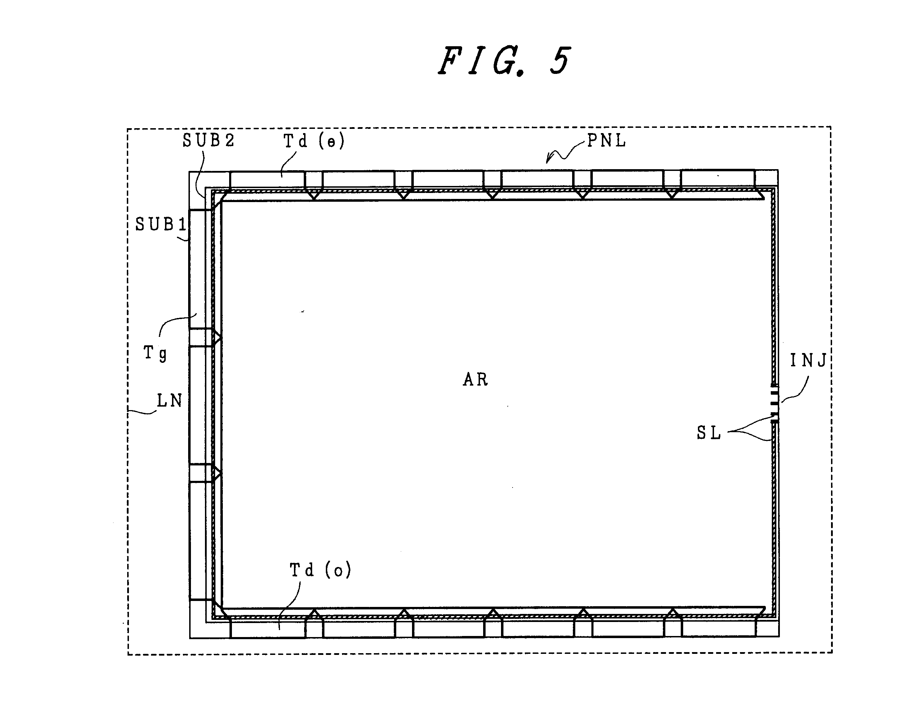

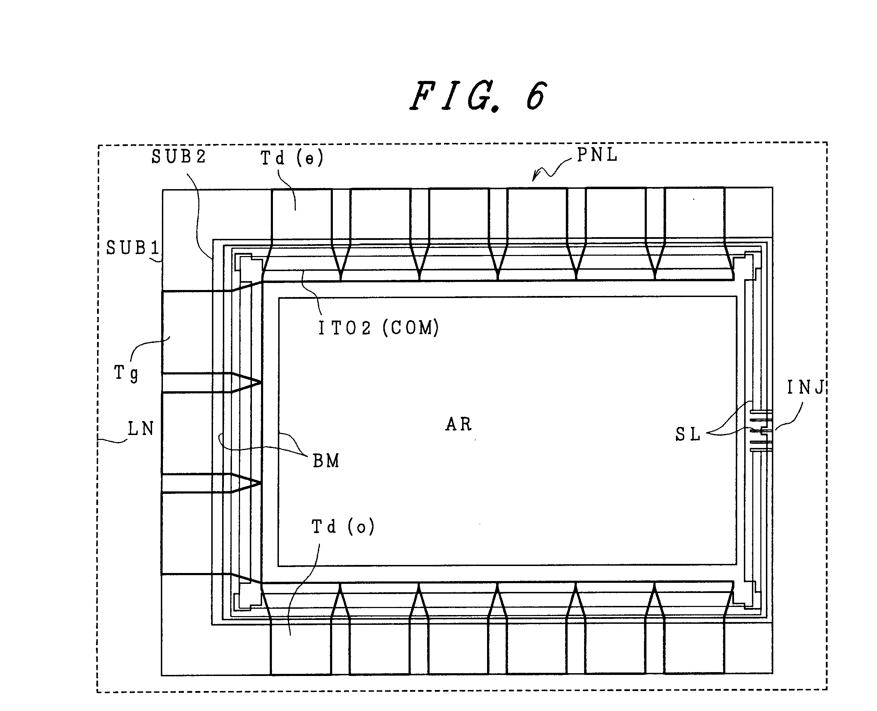

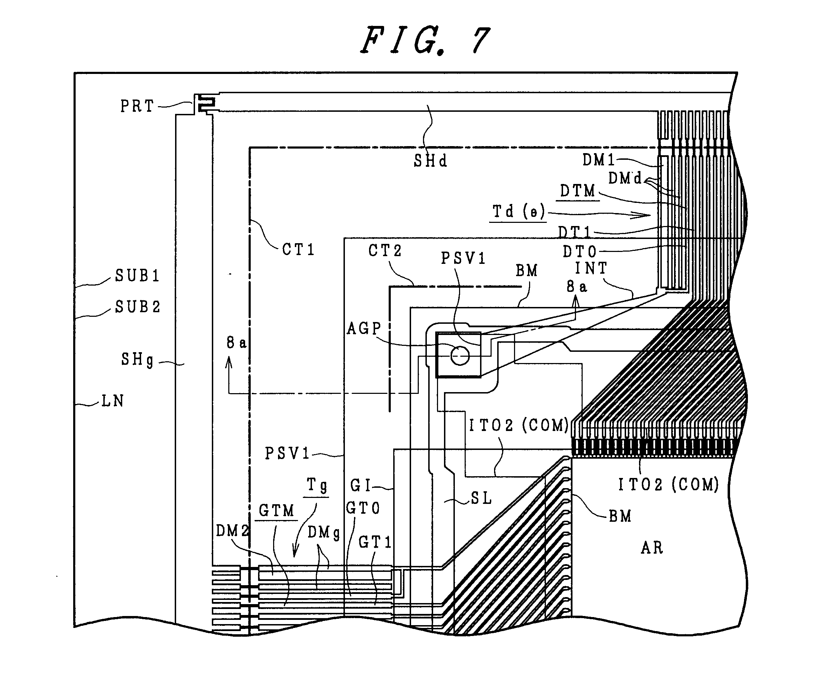

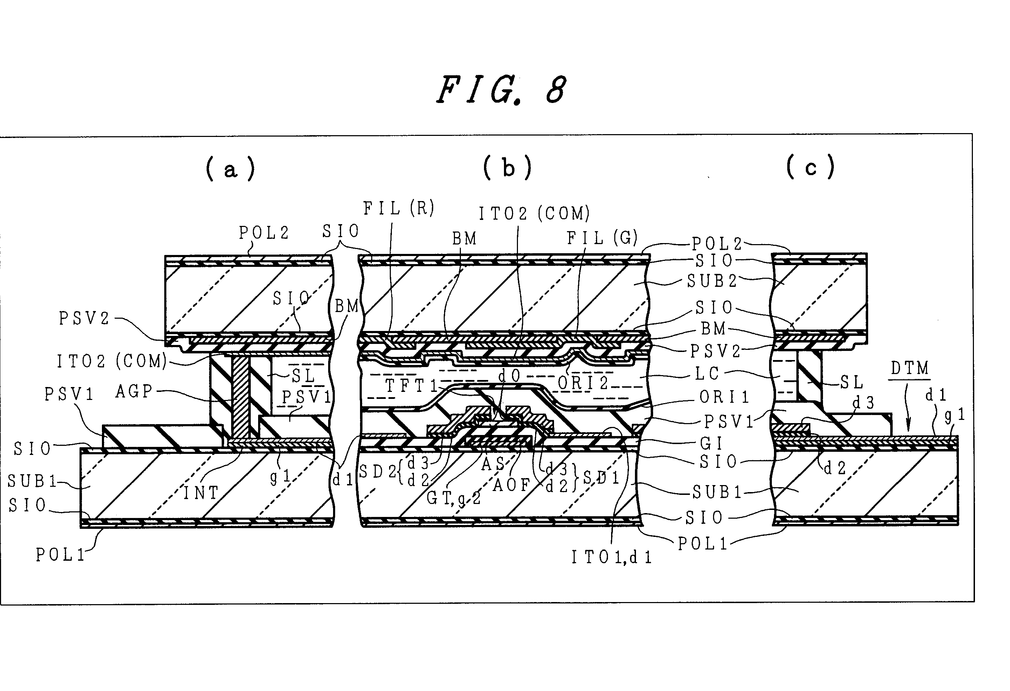

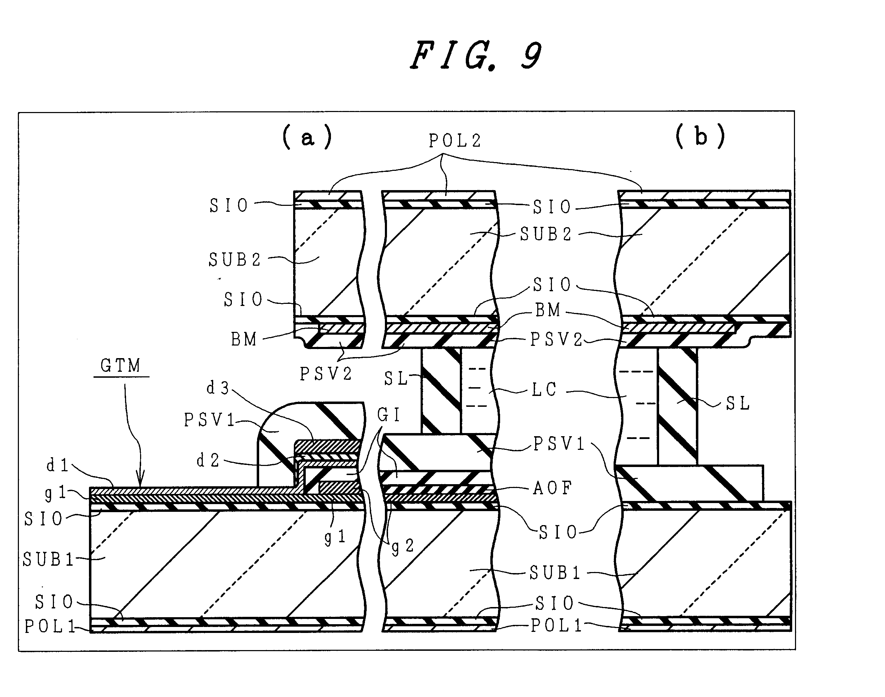

Fig. 5 is a top plan view showing an essential portion of the periphery of a matrix (AR) of a display panel PNL including the upper and lower glass substrates SUB1 and SUB2. Fig. 6 is a top plan view further exaggerating the peripheral portion. Fig. 7 is an enlarged top plan view showing the vicinity of a seal portion SL corresponding to the lefthand upper corner of the panel of Figs. 5 and 6. Moreover, Fig. 8 presents a section of Fig. 2 at the lefthand side, a section taken from line 8a - 9a of Fig. 7 at the righthand side, and a section showing the vicinity of an external connection terminal DTM, to which is connected a video signal drive circuit. Likewise, Fig. 9 presents a section showing the vicinity of an external connection terminal GTM, to which is connected a scanning circuit, at the lefthand side and a section showing the vicinity of a seal portion having no external connection terminal at the righthand side.

The excimer laser beam masks for matrix periphery are prepared in a total of eight kinds, i.e. four kinds, one for each side, and four kinds for corners. As can be imagined from the pattern of terminals Tg and Td in Figure 6, the left side of the matrix periphery is patterned in three steps, the upper side in six steps, the right side in three steps (there is a dummy terminal for test not shown), and the lower side in six steps. The pattern of the whole panel is formed by using each of the eight kinds of masks for matrix periphery and the one kind of mask for matrix section.

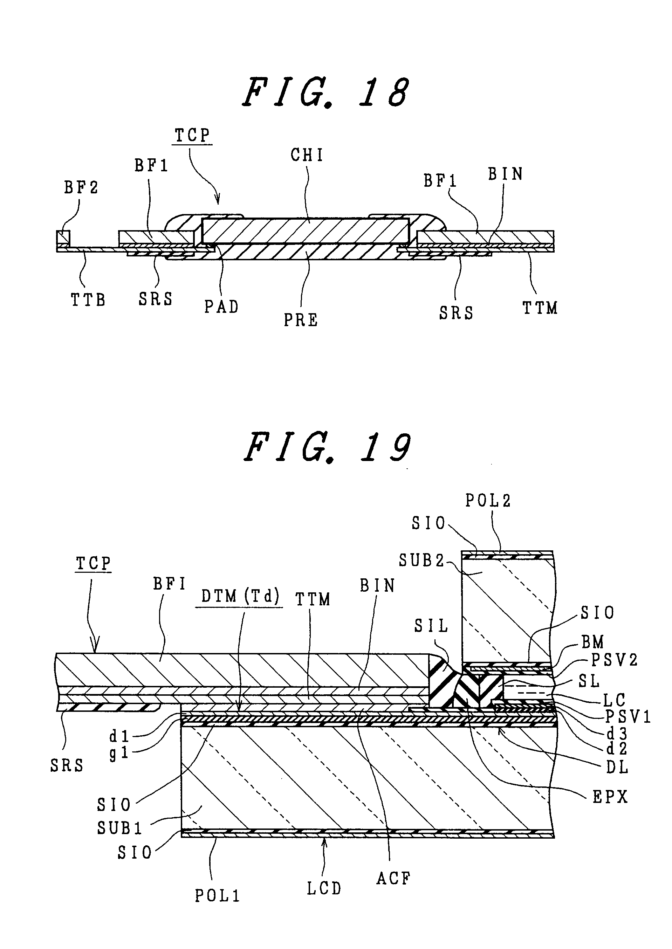

In a fabrication of this panel, a plurality of devices are simultaneously worked and divided by a signal sheet of glass substrate so as to improve the throughput, if the panel has a small size, but a glass substrate having a standardized size for any kind is worked and is reduced to the sizes matching the individual kinds so as to share the fabrication facilities, if the size is large. In either case, the glass is cut after a series of steps. In Figs. 5 to 7 showing the latter example, Figs. 5 and 7 show the state after the upper and lower substrates SUB1 and SUB2 have been cut, and Fig. 7 shows the state before the cutting operation. Letters LN designate the edges of the two substrates before the cutting operation, and characters CT1 and CT2 designates the individual positions at which the substrates SUB1 and SUB2 are to be cut. In either case, the size of the upper substrate SUB2 is so limited to the inside of the lower substrate SUB1 that the portions (as located at the upper and lower sides and the lefthand side in the Figures), in which external connection terminal groups Tg and Td (although suffixes are omitted) are present in the completed state, may be exposed to the outside. The terminal groups Tg and Td are named such that the scanning line connecting terminal GTM, the video signal circuit connecting terminal DTM and their leading lines are collected in plurality at the unit of a tape carrier package TCP (as shown in Figs. 18 and 19) on which is packaged an integrated circuit chip CHI. The leading line from the matrix portion of each group to the external connection terminal portion is inclined toward the two ends. This is because the terminals DTM and GTM of the display panel PNL are made to match the array pitch of the package TCP and the connection terminal pitch at each package TCP.

Between and along the edges of the transparent glass plates SUB1 and SUB2, there is formed the seal pattern SL for sealing the liquid crystal LC excepting a liquid crystal entrance INJ. The seal material is made of an epoxy resin, for example. The common transparent pixel electrode ITO2 at the side of the upper transparent glass substrate SUB2 is connected at the four corners in the present embodiment with a leading line INT, which is formed at the side of the lower transparent glass substrate SUB1, in at least one portion by a silver paste material AGP. The leading line INT is formed at the same fabrication step as that of the later-described gate terminal GTM and drain terminal DTM.

The orientation film ORI1 and ORI2, the transparent pixel electrode ITO1, the common transparent pixel electrode ITO2, and the individual layers are formed in the seal pattern SL. Polarization plates POL1 and POL2 are individually formed on the outer surfaces of the lower transparent glass substrate SUB1 and the upper transparent glass substrate SUB2. The liquid crystal LC is filled in the region which is defined by the seal pattern SL between the lower orientation film ORI1 and the upper orientation film ORI2 for setting the orientations of the liquid crystal molecules. The lower orientation film ORI1 is formed over a passivation film PSV1 at the side of the lower transparent glass substrate SUB1.

This liquid crystal display device is assembled: by superposing the individual layers at the sides of the lower transparent glass substrate SUB1 and the tipper transparent glass substrate SUB2; by forming the seal pattern SL at the side of the substrate SUB2; by superposing the lower transparent glass substrate SUB1 and the upper transparent glass substrate SUB2; by injecting the liquid crystal LC from the opening INJ of the seal member SL to seal the injection entrance INJ with the epoxy resin or the like; and by cutting the upper and lower substrates.

Thin Film Transistor TFT

Next, returning to Figure 2 and Figure 3, we will explain the configuration on the TFT substrate SUB1 side in detail.

If a positive bias is applied to the gate electrode GT, the thin film transistor TFT has its channel resistance reduced between its source and drain. If the bias is reduced to zero, the thin film transistor TFT operates to have its channel resistance increased.

Each pixel is provided with a redundant number (two) of thin-film transistors TFT1, TFT2. These two thin-film transistors TFT1, TFT2 are formed to have substantially the same sizes (in channel length and width) and are each composed of a gate electrode GT, a gate insulating film GI, an i-type (i.e., intrinsic type not doped with a conductivity type determining impurity) amorphous silicon (Si) semiconductor layer AS, and a pair of source electrode SD1 and drain electrode SD2. The source and drain are intrinsically determined by the bias polarity between them, and this polarity is inverted during the operation in the circuit of the present display device. Thus, it should be understood that the source and drain are interchanged during the operation. In the following description, however, one is fixed as the source whereas the other is fixed as the drain, for convenience sake.

Gate Electrode GT

The gate electrode GT is formed to project perpendicularly from the scanning signal lines GL (or branched in the "T-shape"). The gate electrode GT is extended to the regions to be individually formed with the thin film transistors TFT1 and TFT2. These thin film transistors TFT1 and TFT2 have their individual gate electrodes GT integrated (as their common gate electrode) to merge into the scanning signal line GL. The gate electrode GT is constituted by the single level conductive layer g2. The second conductive film g2 may be an aluminum (Al) film formed, for example, by sputtering. On this film is formed an anodized oxide film AOF of aluminum.

This gate electrode GT is formed slightly larger than the i-type semiconductor layer AS so that it can cover it completely (when viewed from below). This prevents the i-type semiconductor layer AS from being exposed to external light or backlight.

Scanning Signal Line GL

The scanning signal line GL is constituted by the second conductive film g2. The second conductive film g2 of the scanning signal line GL is formed at the same step as and integrally with the second conductive film g2 of the gate electrode GT. Moreover, the scanning signal line GL is also formed thereon with the anodized oxide film AOF of Al.

Insulating Film GI

The insulating film GI is used as a gate insulating film to apply an electric field to the semiconductor layer AS as well as the gate electrode in the thin-film transistors TFT1, TFT2. The insulating film GI is formed over the gate electrode GT and the scanning signal line GL. The insulating film GI may be formed of a silicon nitride film prepared by the plasma CVD which has a thickness from 200 Å to 2700 Å (in this embodiment approximately 2000 Å). The gate insulating film GI, as shown in Figure 7, is formed to cover the entire matrix section AR and is removed at its periphery to expose the external connection terminals DTM and GTM. The insulating film GI also contributes to electrical insulation of the scanning signal line GL and video signal line DL.

i-Type Semiconductor Layer AS

The i-type semiconductor layer AS is formed as an isolated island in each of the thin-film transistors TFT1, TFT2 and is made of an amorphous silicon in the thickness range of between 200 Å and 2200 Å (in this embodiment about 2000 Å). The layer d0 is an N(+) type amorphous silicon semiconductor layer doped with phosphor (P) for ohmic contact. This layer remains only where there is an underlying i-type semiconductor layer AS and an overlying conductive layer d2 (d3).

The i-type semiconductor layer AS is also formed between the intersecting portions (or crossover portions) of the scanning signal line GL and the video signal line DL. This crossover i-type semiconductor layer As is formed to reduce the short-circuiting between the scanning signal line GL and the video signal line DL at the intersecting portion.

Transparent Pixel Electrode ITO1

The transparent pixel electrode ITO1 constitutes one of the parts of a pixel electrode of a liquid crystal display.

The transparent pixel electrode ITO1 is connected with both the source electrode SD1 of the thin film transistor TFT1 and the source electrode SD1 of the thin film transistor TFT2. Even if, therefore, one of the thin film transistors TFT1 and TFT2 become defective, a suitable portion may be cut by a laser beam in case the defect invites an adverse action. Otherwise, the situation may be left as it is because the other thin film transistor is normally operating. The laser equipment for defect correction may be a pattern forming excimer laser shown in Figure 1. In this case, a slit that can adjust the opening in the X and Y directions may be set in the path of laser beam in place of the mask 6.

The transparent pixel electrode ITO1 is formed of a first conductive film d1, which is made of a transparent conductive film (Indium-Tin-Oxide (ITO) or NESA film) by sputtering in the thickness range between 1000 Å and 2000 Å (in this embodiment

about 1400 Å).

Source Electrode SD1, Drain Electrode SD2

The source electrode SD1 and the drain electrode SD2 are each formed of a second conductive film d2 in contact with the N(+) type semiconductor layer d0 and a third conductive film d3 formed over the second conductive film d2.

The second conductive film d2 is a sputtered chromium (Cr) film with a thickness of 500 to 1000 Å (in this embodiment about 600 Å). The Cr film is formed in the thickness range not exceeding approximately 2000 Å because too thick a film will increase stresses. The Cr film is used as a barrier layer to improve the adhesion of the third conductive film d3 to the N(+) type semiconductor layer d0 and prevent the aluminum of the third conductive film d3 from diffusing into the N(+) type semiconductor layer d0. As the second conductive film d2, it is possible to use high melting point metal (Mo, Ti, Ta, W) films and their silicide ($MoSi_2$, $TiSi_2$, $TaSi_2$, $WSi_2$) films, in addition to the Cr film.

The third conductive film d3 is formed by aluminum sputtering to a thickness of 3000 Å to 5000 Å (in this embodiment 4000 Å). The aluminum (Al) film has smaller stresses than the Cr film and thus can be formed to a greater thickness, reducing resistance of the source electrode SD1, drain electrode SD2 and video signal line DL, and ensuring a reliable pass over stepped geometry produced by gate electrode GT and i-type semiconductor layer AS. (In other words, it improves a step coverage.)

The second conductive layer d2, third conductive layer d3 and N(+) type semiconductor layer d0 are patterned by the excimer laser using the same mask pattern. The N(+) type semiconductor layer d0 remaining over the i-type semiconductor layer AS is removed self-aligningly with the second conductive film d2 and third conductive film d3. At this time, since the N(+) type semiconductor layer d0 is removed to its full thickness, the i-type semiconductor layer AS is slightly removed at its surface portion. The degree to which the surface is removed can be controlled by the laser beam intensity and radiation time.

Video Signal Line DL

The video signal line DL is formed of the second conductive film d2 and third conductive film d3, the same layers as the source electrode SD1 and drain electrode SD2.

Passivation Film PSV1

Over the thin film transistor TFT and the transparent pixel electrode ITO1, there is formed the passivation film PSV1, which is provided mainly for protecting the thin film transistor TFT against humidity or the like. Thus, the passivation film PSV1 to be used is highly transparent and humidity resistant. The passivation film PSV1 is often made from a silicon oxide film or silicon nitride film formed by a plasma CVD apparatus. In this embodiment it uses a PI organic transparent film with a thickness of about 1 $\mu$m.

The passivation film PSV1 is formed, as shown in Fig. 7, to enclose the entirety the matrix portion AR and is removed at its peripheral portion to expose the external connection terminals DTM and GTM to the outside and at the portion, in which the common electrode COM at the side of the upper substrate SUB2 is connected with the external connection terminal connecting leading line INT of the lower substrate SUB1 by means of the silver paste AGP. In connection with the thickness connection between the passivation film PSV1 and the gate insulating film GI, the former is made thick considering the passivation effect whereas the latter is made thin considering the mutual conductance gm of the transistor. As a result, as shown in Fig. 7, the passivation film PSV1 having a high passivation effect is made so larger than the gate insulating film GI as to have its peripheral portion passivated as wide as possible.

Shielding Film BM

On the upper transparent glass substrate SUB2 side, a shielding film BM is provided that prevents external light or backlight from entering the i-type semiconductor layer AS. A closed polygonal outline of the shielding film BM shown in Figure 2 represents an opening inside of which no shielding film BM will be formed. The shielding film is formed of aluminum or chromium which has good light shielding characteristic. In this embodiment, it is a chromium film formed by sputtering to a thickness of about 1300 Å.

Therefore, the i-type semiconductor layer AS of thin-film transistors TFT1, TFT2 is sandwiched with the overlying shielding film BM and the underlying, slightly larger gate electrode GT, and is shielded against external natural light and backlight. The shielding film BM is formed around each pixel in a lattice shape (so-called black matrix). This lattice defines the effective display region for each pixel. Because the contour of each pixel is clearly defined by the shielding film BM, the contrast improves. In other words, the shielding film BM has two functions of blocking light from entering the i-type semiconductor layer AS and serving as a black matrix.

Since the edge portion of the transparent pixel electrode ITO1 on the foot side of the rubbing direction (lower right portion in Figure 2) is also shielded by the shielding film BM, even if a domain is induced at the above portion, the display characteristic will not deteriorate because the domain is not seen.

The shielding film BM is additionally formed at its peripheral portion with a framed pattern, as shown in Fig. 6, which is formed to merge into the pattern of the matrix portion having a plurality of dot-shaped openings, as shown in Fig. 2. The shielding film BM at the peripheral portion is extended to the outside of the seal portion SL, as shown in Figs. 6 to 9, thereby to prevent the leakage light such as the light reflected from an implemented machine such as a personal computer from entering the matrix portion. On the other hand, the shielding film BM is limited to the inside of the edge of the substrate SUB2 within about 0.3 to 1.0 mm and is formed to avoid the cut region of the substrate SUB2.

Color Filter FIL

The color filters FIL are formed in stripes of repeating colors-red, green and blue-at positions facing each pixel. The color filter FIL is formed large enough to cover the entire transparent pixel electrode ITO1, and the shielding film BM is formed inside the periphery of the transparent pixel electrode ITO1 so that it overlaps the edge portions of the color filter FIL and the transparent pixel electrode ITO1.

The color filter FIL may be formed as follows. First, a dyeing base such as acrylic resin is formed over the surface of the upper transparent glass substrate SUB2. The dyeing base in areas other than those where red filter will be formed is removed by photolithography. Then, the remaining dyeing base is dyed with red dye and fixed to form a red filter R. Similar steps are followed to subsequently produce a green filter G and a blue filter B.

Passivation Film PSV2

The passivation film PSV2 is provided for preventing dyes of color filters FIL from leaking into the liquid crystal LC. The passivation film PSV2 may use such transparent resin materials as acrylic resin and epoxy resin.

Common Transparent Pixel Electrode ITO2

The common transparent pixel electrode ITO2 is opposed to the transparent pixel electrode ITO1, which is provided for each pixel at the side of the lower transparent glass substrate SUB1, so that the liquid crystal LC has its optical state varied in response to the potential difference (or electric field) between each pixel electrode ITO1 and the common pixel electrode ITO2. This common transparent pixel electrode ITO2 is fed with the common voltage Vcom. In the present embodiment, this common voltage Vcom is set at an intermediate potential between a driving voltage Vdmin at the low level and a driving voltage Vdmax at the high level, both of which are applied to the video signal line DL. An AC voltage may be applied in case the supply voltage of the integrated circuit to be used in the video signal drive circuit is to be reduced to one half. Incidentally, the top plan shape of the common transparent pixel electrode ITO2 should be referred to Figs. 6 and 7.

Structure of Latching Capacitor Cadd

The transparent pixel electrode ITO1 is formed to overlap the adjoining scanning signal line GL at the end opposed to the end to be connected with the thin film transistor TFT. This superposition constitutes a latching capacity element (or an electrostatic capacity element) Cadd which uses the transparent pixel electrode ITO as its one electrode PL2 and the adjoining scanning signal line GL as its other electrode PL1, as is apparent from Figs. 4. This latching capacity element Cadd has its dielectric films formed of: the insulating film GI used as the gate insulating film of the thin film transistor TFT; and the anodized film AOF.

The latching capacitor Cadd is formed in the widened portion of the second conductive layer g2 of the scanning gate line GL. Here, the second conductive film g2 at the portion intersecting the video signal line DL is thinned to reduce the probability of the short-circuiting with the video signal line DL.

Even if the transparent pixel electrode ITO1 is broken at the stepped portion of the electrode PL1 of the latching capacitor Cadd, its defect is compensated by the island region which is constructed of the second conductive film d2 and the third conductive film d3 formed cross that step.

Gate Terminal Portion

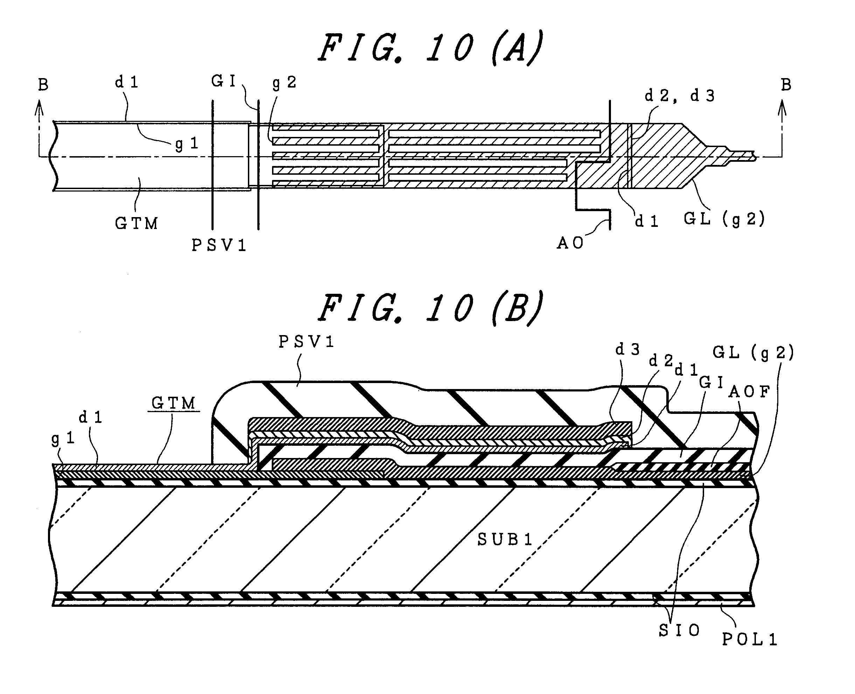

Fig. 10 presents a connection structure from the scanning signal line GL of the display matrix to its external connection terminal GTM, and (A) is a top plan view whereas (B) is a section taken along line B - B of (A). Incidentally, Fig. 9 corresponds to the lower portion of Fig. 7, and the hatched line portions are shown by straight lines for conveniences.

Letters AO designate a photolithographic mask pattern, namely, a photo resist pattern for selective anodization. As a result, this photo resist is anodized and then removed so that the shown pattern AO is not left as a complete but as a trace because the oxide film AOF is selectively formed in the gate line GL, as shown in section. With reference to the boundary line AO of the photoresist in the top plan view, the lefthand side is the region which is covered with the resist and is not anodized, whereas the righthand side is the region which is exposed from the resist to the outside and is anodized. The anodized Al layer g2 has its surface formed with its oxide $Al_2O_3$ film AOF and its lower conductive portion reduced in volume. Of course, the anodization is so carried out for a proper time and at a proper voltage that the conductive portion may be left. The mask pattern AO is made to intersect the scanning line GL not in a straight line but in a folded crank shape.

The Al layer g2, as shown, is hatched for easy understanding, but the region left non-anodized is patterned in a comb shape. This is intended to suppress the probability of the line breakage and the sacrifice of the conductivity to the minimum while preventing any formation of whiskers by narrowing the width of each Al layer and bundling a plurality of them in parallel, because the whisker will occur in the surface for the wide Al layers. In the present embodiment, therefore, the portion corresponding to the root of the comb is displaced along the mask AO.

The gate terminal GTM is formed of: a Cr layer g1 having an excellent contact with the silicon oxide SiO layer and a higher resistance to galvanic corrosion than Al or the like; and the transparent conductive layer d1 protecting the surface of the Cr layer g1 and having the same level (belonging to the same layer and formed simultaneously) as the pixel electrode ITO1. Incidentally, the conductive layers d2 and d3 formed over and on the sides of the gate insulating film GI are left as a result that the conductive layers g2 and gl are covered with the photo resist so that they may not be etched off by pin holes or the like at the time of etching the conductive layers d3 and d2. Moreover, the ITO layer d1 extended right ward across the gate insulating film GI is provided for further completing the similar countermeasures.

In the top plan view, the gate insulating film GI is formed at the more righthand side than its boundary, and a passivation film PSV1 is also formed at the more righthand side than the boundary so that the terminal portion GTM at the lefthand side can be exposed from them into electric contact with the external circuits. Although only one pair of the gate line GL and the gate terminal is shown, a plurality of pairs are arranged vertically in Fig. 7, as a matter of fact, to constitute the terminal group Tg (as shown in Figs. 6 and 7), and the gate terminals have their lefthand ends are extended in the fabrication process across the cut region CT1 of the substrate and are short-circuited by a line SHg. This short-circuiting line SHg in the fabrication process is useful for supplying the electric power at he anodizing time and for preventing the electrostatic breakdown at the time of rubbing to orientation film ORI1.

< Drain Terminal DTM

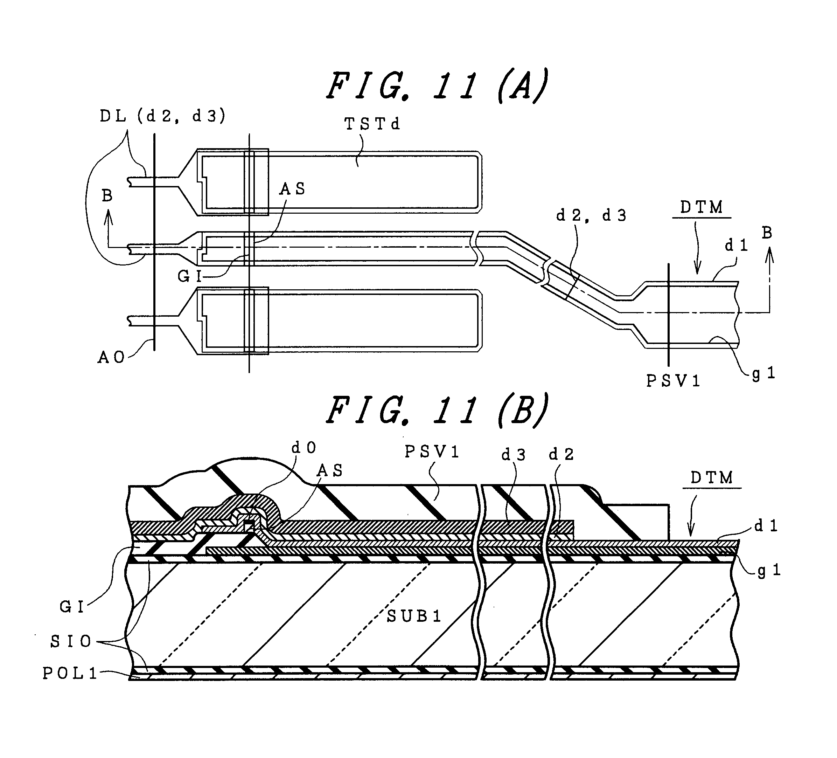

Fig. 11 is a diagram showing the connection from the video signal line DL to its external connection terminal DTM, and (A) presents a top plan view whereas (B) presents a section taken along line B - B of (A). Incidentally, Fig. 10 corresponds to the upper righthand portion of Fig. 7 and has its righthand direction corresponding to the upper end portion (or the lower end portion) of the substrate SUB1, although the direction of the drawing is changed for conveniences.

Letters TSTd designate a test terminal which is not connected with any external terminal but widened to contact with a probe or the like. Likewise, the drain terminal DTM is also made wider than the wiring portion as to connected with the external terminal. The test terminal TSTd and the external connection drain terminal DTM are so alternately arrayed in plurality as to be vertically staggered so that the test terminal TSTd terminates without reaching the end portion of the substrate SUB1, as shown. But, the drain terminals DTM constitute the terminal group Td (whose suffix is omitted), as shown in Fig. 7, and are further extended across the cut line CT1 of the substrate SUB1 so that all of them are short-circuited to each other through lines SHd so as to prevent any electrostatic breakdown during the fabrication step. The drain connection terminals are connected to the opposite sides of the video signal lines DL, in which the test terminal TSTd are present, across the matrix, whereas the test terminals are connected to the opposite sides of the video signal lines DL, in which the drain connection terminals DTM are present, across the matrix.

By a reason similar to the gate terminal GTM, the drain connection terminal DTM is formed of two layers, i.e., the Cr layer g1 and the ITO layer d1 and is connected with the video signal line DL through the portion, from which is removed the gate insulating film GI. The semiconductor layer AS formed over the end portion of the gate insulating film GI is provided for etching the edge of the gate insulating film GI in a taper shape. For connection with an external circuit, the passivation film PSV1 is naturally removed from the terminal DTM. Letters AO designate the aforementioned anodizing mask which has its boundary formed to enclose the entirety of the matrix. As shown, the lefthand side is covered with the mask, but the remaining uncovered portion has no layer g2 so that it has no relation to the pattern.

The leading lines from the matrix portion to the drain terminal portion DTM are constructed, as shown at (C) in Fig. 8, such that the layers d2 and d3 at the same level as the video signal lines DL are laminated midway of the seal pattern SL just over the layers d1 and g1 at the same level as the drain terminal portion DTM. This construction is intended to minimize the probability of breakage of lines thereby to protect the galvanically corrosive Al layer as much as possible with the passivation film PSV1 and the seal pattern SL.

Equivalent Circuit of Whole Display Circuit

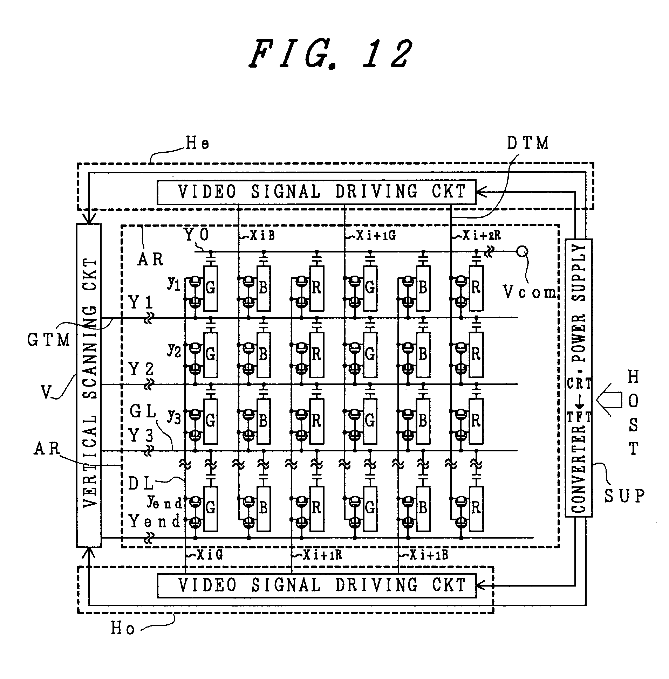

Fig. 12 shows an equivalent circuit diagram of the display matrix portion and a wiring diagram of its peripheral circuits. Although this drawing is a circuit diagram, it is depicted in a manner to correspond to a practical geometric disposition. Letters AR designate a matrix array formed by disposing a plurality of pixels two-dimensionally.

In the drawing, letter X designates the video signal line, and suffixes G, B and R are added to correspond to green blue and red pixels, respectively. Letter Y designates the scanning signal line GL, and suffixes 1, 2, 3, - - -, and so on are added in accordance with the sequence of the scanning timing.

The video signal line X (whose suffix is omitted) is alternately connected with the upper (or odd-numbered) video signal driving circuit He and with the lower (or even-numbered) video signal driving circuit Ho.

The scanning signal line Y (whose suffix is omitted) is connected with a vertical scanning circuit V.

Letters SUP designate a circuit which includes a power, supply circuit for obtaining a plurality of divided and stabilized voltage sources from one voltage source, and a circuit for converting data for CRT (i.e., Cathode Ray tube) from a host (i.e., a higher-order operational processor) to data for the TFT liquid crystal display device.

Working of Latching Capacitor Cadd

The latching capacity element Cadd functions to reduce the influences of the gate potential variation delta Vg upon the center potential (e.g., the pixel electrode potential) V1c when the thin film transistor TFT switches, as expressed by the following formula:

$$\Delta V1c = \{Cgs/(Cgs + Cadd + Cpix)\} \times \Delta Vg,$$

where Cgs represents a parasitic capacitance formed between the gate electrode GT and source electrode SD1 of the thin-film transistor TFT; Cpix represents a capacitance formed between the transparent pixel electrode ITO1(PIX) and the common transparent pixel electrode IT02(COM); and $\Delta V1c$ represents the amount of change in the pixel electrode potential caused by $\Delta Vg$. This variation delta V1c causes the DC component to be added to the liquid crystal LC and can be reduced the more for the higher latching capacitor Cadd. Moreover, the latching capacitor Cadd functions to elongate the discharge time and stores the video information for a long time after the thin film transistor TFT is turned off. The DC component to be applied to the liquid crystal LC can improve the lifetime of the liquid crystal LC, to reduce the so-called "printing", by which the preceding image is left at the time of switching the liquid crystal display frame.

Since the gate electrode GT is enlarged to such an extent as to cover the semiconductor layer AS completely, as has been described hereinbefore, the overlapped area with the source electrode SD1 and the drain electrode SD2 is increased to cause an adverse effect that the parasitic capacity Cgs is increased to make the center potential V1c liable to be influenced by the gate (scanning) signal Vg. However, this demerit can be eliminated by providing the latching capacitor Cadd.

The latching capacity of the latching capacitor Cadd is set from the pixel writing characteristics to a level four to eight times as large as that of the liquid crystal capacity Cpix (4 * Cpix < Cadd < 8 * Cpix) and eight to thirty two times as large as that of the capacity Cgs (8 * Cgs < Cadd < 32 * Cgs).

The initial stage scanning signal line GL (i.e., $Y_0$) to be used only as the capacity electrode line is set to the same potential as that of the common transparent pixel electrode (Vcom) ITO2. In the example of Fig. 7, the initial stage scanning signal line is short-circuited to the common electrode COM through the terminal GTO, the leading line INT, a terminal DTO and an external line. Alternatively, the initial stage latching capacity electrode line $Y_0$ may be connected with the final stage scanning signal line Y-end or a DC potential point (or AC ground point) other than the Vcom, or connected to receive one excess scanning pulse $Y_0$ from the vertical scanning circuit V.

Method of Manufacture

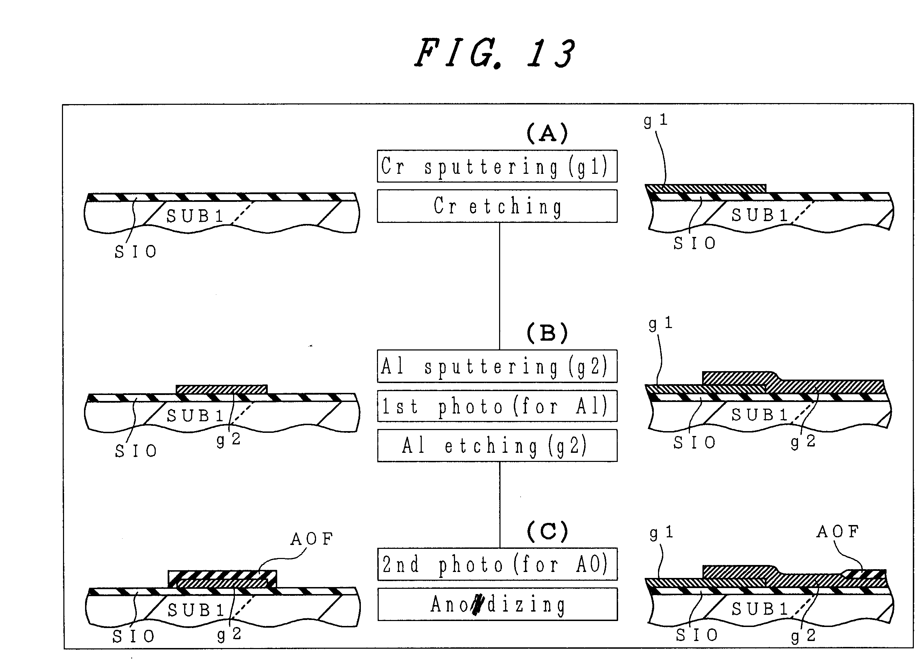

Next, by referring to Figures 13 through 15, the steps of manufacturing the substrate SUB1 side of the above-mentioned liquid crystal display device will be described. In these figures, the central letters indicate the abbreviations of the step names, with the left-hand side representing the pixel portions in Figure 3 and the right-hand side representing the process flow, as viewed in section in the vicinity of the gate terminals shown in Figure 10. Steps A to I except for step D correspond to the individual patterning steps. The cross section of each step indicate the state after the patterning process has been finished.

This embodiment uses eight kinds of patterning mask, of which five are used for excimer laser and the remaining three are used for the conventional photolithography (photo processing) technology. These two techniques are selected depending on manufacturing conditions such as the material of the film to be processed and the underlying layer.

In the following description, the photo processing means a series of operations ranging from the coating of photoresist to selective exposure using mask to development of exposed photoresist. Repetitive explanation on the photo processing will be omitted. Now, each of the divided processes will be described in the following.

Step A, Fig. 13

On a lower transparent glass substrate SUB1 made of 7059 glass (product name) a silicon oxide film SIO is deposited on both sides by dip treatment and is baked at 500 °C for 60 minutes. The lower transparent glass substrate SUB1 is then sputtered with chromium to form the first conductive film g1 to a thickness of 1100 Å. The chromium layer g1 is selectively irradiated with a beam of the excimer laser. The laser wavelength is 248 nm and the energy density 0.3 J/cm². This process forms gate terminals GTM, drain terminals DTM, anodic oxidized bus lines SHg connecting the gate terminals GTM, bus lines SHd short-circuiting the drain terminals DTM, and anodic oxidized pads (not shown) connected to the anodic oxidized bus lines SHg.

Step B, Fig. 13

A second conductive film g2 having a thickness of 2,800 angstroms and made of Al-Pd, Al-Si, Al-Si-Ti or Al-Si-Cu is formed by the sputtering. After the photolithographic treatment, the second conductive film g2 is selectively etched with a mixed acid solution of phosphoric acid, nitric acid and glacial acetic acid.

Step C, Fig. 13

After the photolithographic treatment (i.e., after the formation of the aforementioned anodization mask AO), the substrate SUB1 is dipped in the anodizing liquid which is prepared by diluting a solution containing 3% of tartaric acid adjusted to PH 6.2 to 6.3 with a solution of ethylene glycol, and the anodizing current density is adjusted to 0.5 mA/cm$^2$ (for anodization at a constant current). Next, an anodization is carried out till an anodization current of 125 V necessary for a predetermined $Al_2O_3$ film thickness is reached. After this, the substrate SUB1 is desirably held in this state for several ten minutes (for anodization at a constant voltage). This is important for achieving a uniform $Al_2O_3$ film. Thus, the conductive film g2 is anodized to form an anodized film AOF having a thickness of 1,800 angstroms over the scanning signal line GL, the gate electrode GT and the electrode PL1.

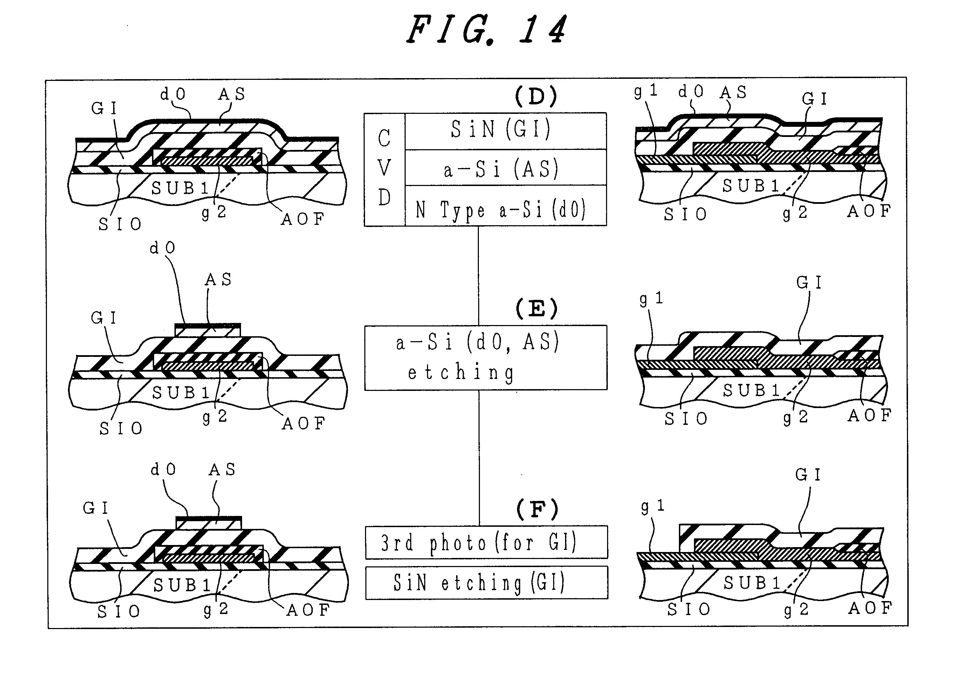

## Step D, Fig. 14

Ammonia gas, silane gas and nitrogen gas are introduced into a plasma CVD apparatus to form a Si nitride film having a thickness of 2,000 angstroms, and silane gas and hydrogen gas are introduced into the plasma CVD apparatus to form an i-type amorphous Si film having a thickness of 2,000 angstroms. After this, hydrogen gas and phosphine gas are introduced into the plasma CVD apparatus to form an N(+)-type amorphous Si film having a thickness of 300 angstroms.

## Step E, Fig. 14

An excimer laser beam with wavelength of 248 nm and energy density of 2 J/cm$^2$ is irradiated to selectively remove N(+) type amorphous silicon film and i-type amorphous silicon film to form isolated islands of i-type semiconductor layer.

## Step F, Fig. 14

After the photolithography, the Si nitride film is selectively etched by using $SF_6$ as the dry etching gas.

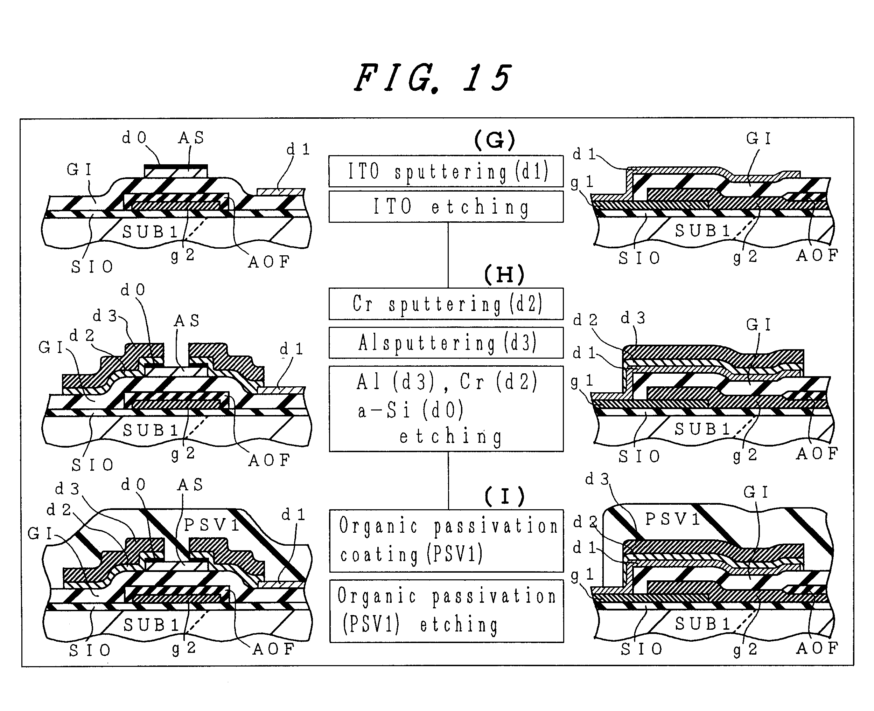

## Step G, Fig. 15

A first conductive film d1 formed of an ITO film having a thickness of 1,400 angstroms is formed by the sputtering. By using an excimer laser beam with wavelength of 248 nm and energy density of 1 J/cm$^2$, the first conductive film d1 is selectively removed to form gate terminals GTM, the uppermost layer of drain terminals DTM, and transparent pixel electrodes ITO1.

## Step H, Fig. 15

A second conductive film d2 of Cr having a thickness of 600 angstroms is formed by the sputtering, and a third conductive film d3 of Al-Pd, Al-Si, Al-Si-Ti or Al-Si-Cu having a thickness of 2,000 angstroms is formed by the sputtering. By irradiating an excimer laser beam with wavelength of 193 or 248 nm and energy density of 0.8 J/cm$^2$, the third conductive film d3 and the second conductive film d2 are selectively removed to form video signal lines DL, source electrodes SD1 and drain electrodes SD2 while at the same time selectively removing the N(+) type semiconductor layer d0 between the exposed source and drain.

## Step I, Fig. 15

A PI organic transparent passivation film 1 μm thick is coated by spinner. The organic passivation film is selectively removed by radiating an excimer laser beam with wavelength of 308 nm and energy density of 0.1 J/cm$^2$ to form a passivation film PSV1.

## Structure of whole Liquid Crystal Display module

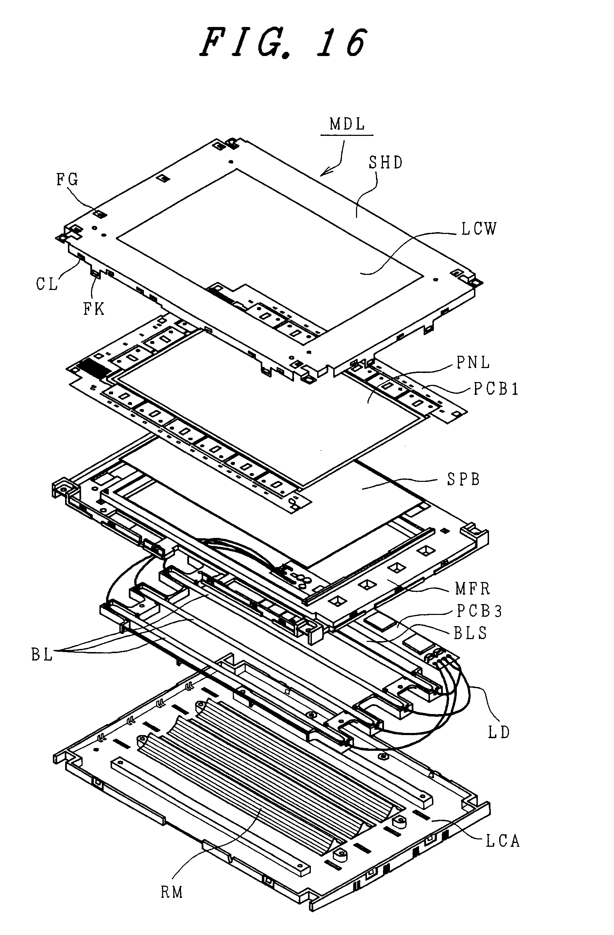

Fig. 16 is an exploded perspective view showing a liquid crystal display module MDL.

Letters SHD designate a shield casing (= metal frame) made of a metal plate; letters LCW designate a liquid crystal display window; letters PNL designate a liquid crystal display panel; letters SPB designate an optical diffusion plate; letters MFR designate a middle frame; letters BL designate back lights; letters BLS designate a back light support; and letters LCA designate a lower casing. All of these members are stacked in vertical positions, as shown, to assemble a module MDL.

The module MDL is firmly secured by a claw CL and a hook FK formed on the shield case SHD.

The intermediate frame MFR is formed into the shape of frame to provide an opening corresponding to the display window LCW, and its frame portion is provided with bulges and recesses according to the shape and thickness of the dispersion board, backlight support BLS and various circuit components, as well as with openings for heat dissipation.

The lower case LCA also serves as a reflector for backlight and has reflection bulges corresponding to the fluorescent lamps BL for efficient reflection.

## Display Panel PNL and Drive Circuit Board PCB1

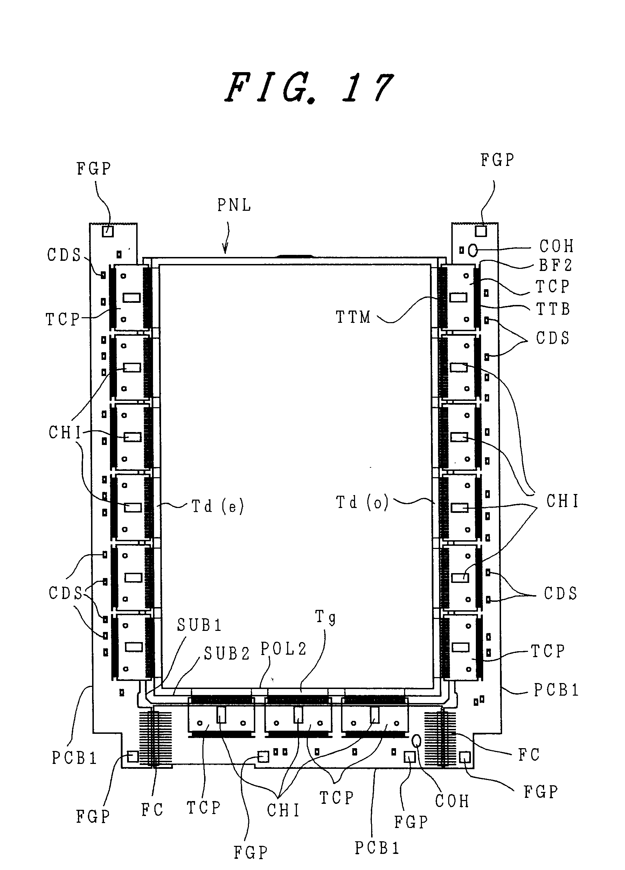

Figure 17 is a top view showing the display panel PNL connected with the video signal drive circuits He, Ho and the vertical scanning circuit V.

Letters CHI designate drive IC chips (of which: the lower three are the drive IC chips at the vertical scanning circuit side whereas the righthand and lefthand six are the drive IC chips at the video signal drive circuit side) for driving the display panel PNL. Letters TCP designate tape carrier packages in which are packaged the driving IC chips CHI by the tape automated bonding method (TAB), as described hereinafter with reference to Figs. 18 and 19, and letters PCB1 designate drive circuit substrates divided into three in which are individually implemented the tape carrier packages TCP and capacitors CDS. Denoted FGP is a frame ground pad, to which a spring-like fragment FG cut into the shield case SHD is soldered. A symbol FC represents a flat cable that provides an electrical connection between the lower side drive circuit board PCB1 and the left side drive circuit board PCB1 and also between the lower side drive circuit board PCB1 and the right side drive circuit board PCB1. The flat cable FC, as shown in the figure, consists of a plurality of lead wires (made of phosphor bronze plated with Sn) supported and sandwiched by striped polyethylene layer and polyvinyl alcohol layer.

TCP Connection Structure

Figure 18 shows the cross-sectional structure of a tape carrier package TCP that consists of an integrated circuit chip CHI mounted on a flexible wiring board which provides the scanning signal drive circuit V and the video signal drive circuits He, Ho. Figure 19 is a fragmentary cross section showing the tape carrier package TCP connected, in this example, to the video signal circuit terminal DTM of the liquid crystal display panel.

In the figure, TTB represents an input terminal and wiring portion of the integrated circuit CHI. TTM is an output terminal and wiring portion of the integrated circuit CHI. These are made, for example, of Cu and their inner ends (usually called inner leads) are connected to the bonding pads PAD of the integrated circuit CHI by the so-called facedown bonding method. Outer ends of the terminals TTB and TTM (usually called outer leads) correspond to the input and output of the semiconductor integrated circuit chip CHIP, respectively, and are connected, as by solder, to the CRT/TFT conversion circuit and power supply circuit and through an anisotropic conductive film ACF to the liquid crystal display panel PNL. The package TCP is connected to the panel in such a way that its end portions cover the passivation film PSV1, which exposes the connection terminal DTM on the panel PNL side. Thus, the outer connection terminal DTM (GTM) is covered at least by the passivation film PSV1 or package TCP and therefore has a greater resistance against galvanic corrosion.

Designated BF1 is a base film made of polyimide; and SRS is a solder resist film that works as a mask to prevent excess solder from adhering to unwanted areas. The gap between the upper and lower glass substrates outside the seal pattern SL is protected by epoxy resin EPX after cleaning. Further, silicone resin SIL is filled between the package TCP and the upper substrate SUB2, thus providing multiple protection.

Drive Circuit Substrate PCB2

The drive circuit substrate PCB2 of the liquid crystal display LCD to be held and mounted in the middle frame MFR is formed into an L-shape, as shown in Fig. 30, to implement electronic parts such as ICs, capacitors or resistors. In this drive circuit substrate PCB2, there are mounted a power supply circuit for achieving a plurality of divided stable voltage sources from one voltage source and a circuit including a circuit for converting data for CRT (i.e., Cathode Ray Tube) from a host (i.e., a higher-order operational processor) to data for the TFT liquid crystal display device. Letters CJ designate a connector connection portion to be connected with a not-shown connector to be connected with the outside. The drive circuit board PCB2 and the inverter circuit board PCB3 are electrically interconnected by a backlight cable passing through a connector hole provided in the intermediate frame MFR.

The drive circuit board PCB1 and the drive circuit board PCB2 are electrically connected to each other through a flexible flat cable FC. During assembly, the drive circuit board PCB2 is placed in overlapping contact with the back side of the drive circuit board PCB1 by bending the flat cable 180 degrees and is fit into a recess in the intermediate frame MFR.

As mentioned above, the irradiation of a solid material (films) with the excimer laser beam leads to a decomposition of molecules and breaking of bonds of metal layers, etc., accompanied by the formation of fine particles and/or gaseous products which are dispersed with nearly supersonic speed or even a higher speed. These debris must be prevented from scattering over the respective surface for not impairing the subsequent processing steps.

The present invention provides means for removing the particular and/or gaseous decomposition products from the irradiated surface portions.

Fig. 22(A) shows a first embodiment of the respective apparatus of the present invention. For the sake of illustration, a substrate SUB1 is shown provided with an SiO layer SIO and an electrically conductive film g2. The device comprises a shield plate 10 having at least one opening 18 through which the beam of the excimer laser 1 may irradiate the exposed surface portion.

The shield plate is provided at a small distance from the exposed surface thus defining a channel 19 through which a purging gas is led over the surface by blowing and/or by sucking at a suitably arranged connecting portion. The shield plate 10 shields the substrate (SUB1) from the beam of the excimer laser 1 and guides the flow in the channel 19. A combination of both blowing and sucking is preferred. In view of the very high speed of dispersion of the debris 11, the speed of the flow 12 indicated by the arrows is preferably higher than that of the expansion of the debris 11.

The flow 12 in this kind of device is preferably laminar. It is produced by using high pressure input gas and/or high rate sucking at the outlet portion.

Debris 11 which could pass through the hole 18 of the shield plate 10 may be eliminated using a similar blowing and/or sucking system comprising an inlet and an outlet port.

Fig. 22(B) shows another preferred embodiment of the device for removing debris produced by the excimer laser irradiation. As in Fig. 22(A), an electrically conductive layer g2 provided on an SiO layer SIO on a substrate SUB1 is irradiated with the beam of an excimer laser 1 in a predetermined surface area. The device comprises a nozzle 13 connected to a purging gas source the opening of the nozzle 13 being appropriately shaped and disposed in the vicinity of the irradiated surface portion and at a small distance from the surface, preferably inclined thereto. The debris 11 formed by the irradiation are blown away by the gas flow 12 from the nozzle 13 which is preferably intermittent and/or a shock flow. The device further comprises a shield plate 20 arranged in a similar manner as the shield plate 10 in Fig. 22(A), and being connected to an outlet port, optionally connected to a sucking device. The shield plate 20 is preferably disposed such that it is inclined, the lower edge being in the vicinity of the irradiated area.

The above-explained means according to the present invention effectively prevent scattering of decomposition products over the substrate surface and thus lead to a considerable increase of both product yield and quality.

Embodiment 2

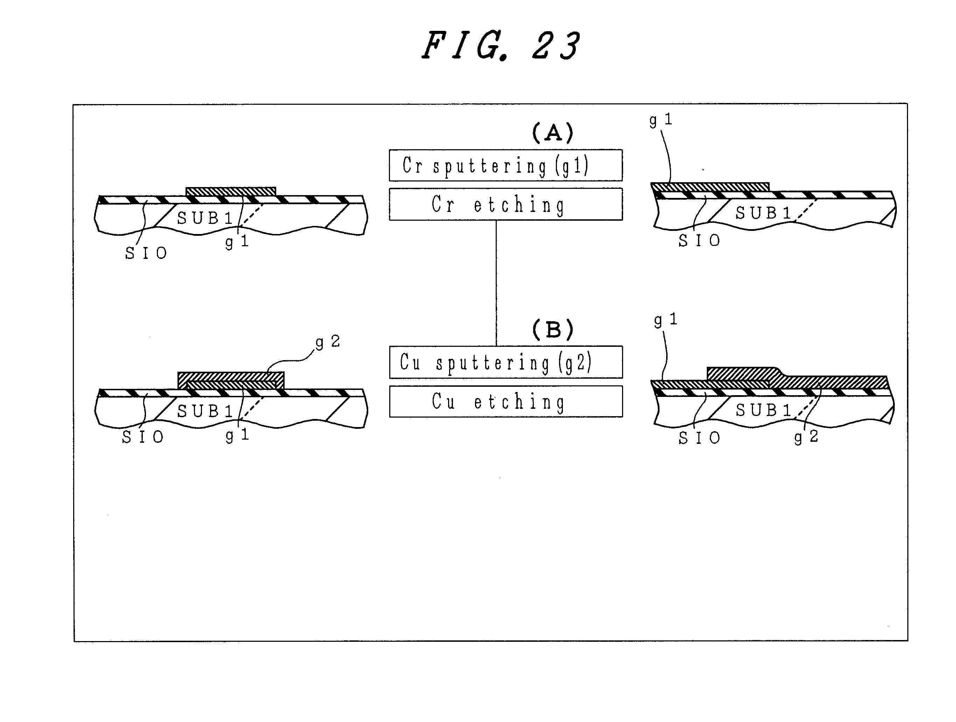

Figure 23 through Figure 25 show a process flow of another embodiment of this invention and correspond to Figure 13 to Figure 15 of the first embodiment. What differs greatly from the first embodiment is that the second conductive film g2 is made mainly of Cu instead of Al and that tie gate electrode GT and gate line GL are formed as a multilayer structure consisting of the first conductive film g1 and the second conductive film g2, rather than forming the anodic oxide film AOF.

Step A, Fig. 23

The lower transparent glass substrate SUB1 made of 7059 glass (product name) is formed with a silicon oxide film SIO on both sides by dipping and then subjected to baking at 500°C for 60 minutes. The lower transparent glass substrate SUB1 is sputtered with chromium (or Ta) to deposit a first conductive film g1 to a thickness of 1100 Å, which is selectively radiated by excimer laser beam. The laser has a wavelength of 248 nm and energy density of 0.3 J/cm$^2$. This process forms gate terminals GTM, drain terminals DTM, bus lines SHg that short-circuit the gate terminals GTM, and bus lines SHd that short-circuit the drain terminals DTM.

Step B, Fig. 23

A second conductive film g2 of Cu is deposited to a thickness of 1500 Å by sputtering. It is radiated with an excimer laser beam having a wavelength of 248 nm and an energy density of 0.15 J/cm$^2$ and is selectively removed.

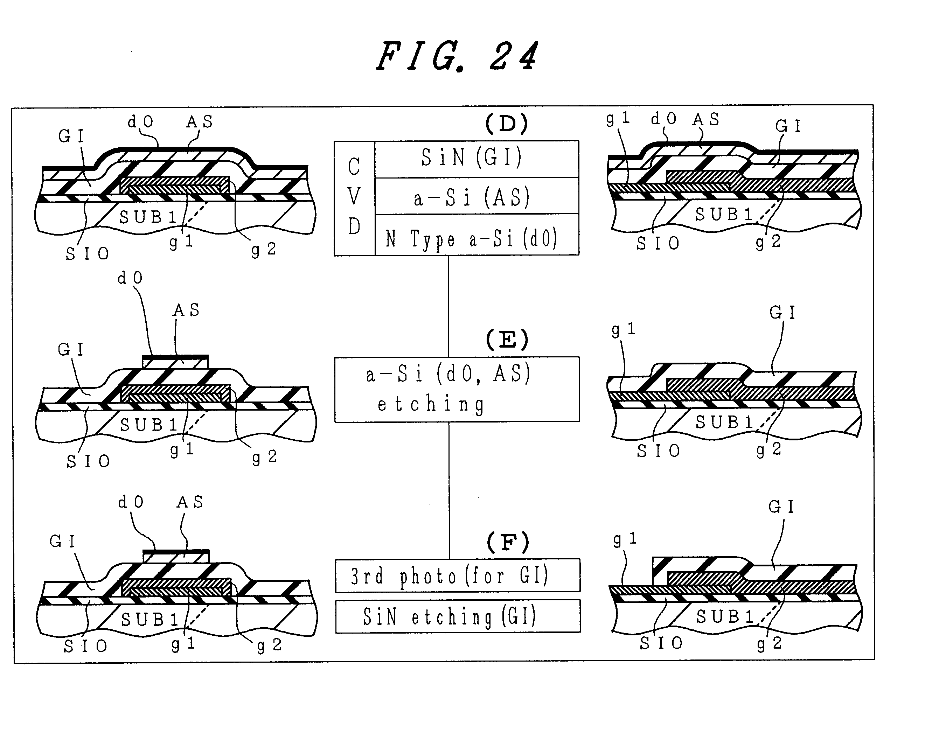

Step C, Fig. 24

Ammonia gas, silane gas and nitrogen gas are introduced into the plasma CVD apparatus to deposit a silicon nitride film to a thickness of 2000 Å. Then silane gas and hydrogen gas are introduced into the plasma CVD apparatus to deposit an i-type amorphous silicon film to a thickness of 2000 Å, followed by introduction of hydrogen gas and phosphine gas into the apparatus to form an N(+) type amorphous silicon film with a thickness of 300 Å.

Step D, Fig. 24

The N(+) type amorphous silicon film and i-type amorphous silicon film are selectively removed by radiating an excimer laser with a wavelength of 248 nm and an energy density of 2J/cm$^2$ to form islands of i-type semiconductor layer AS.

Step E, Fig. 24

After photo processing, SF6 gas is used as a dry etching gas to selectively etch the silicon nitride film.

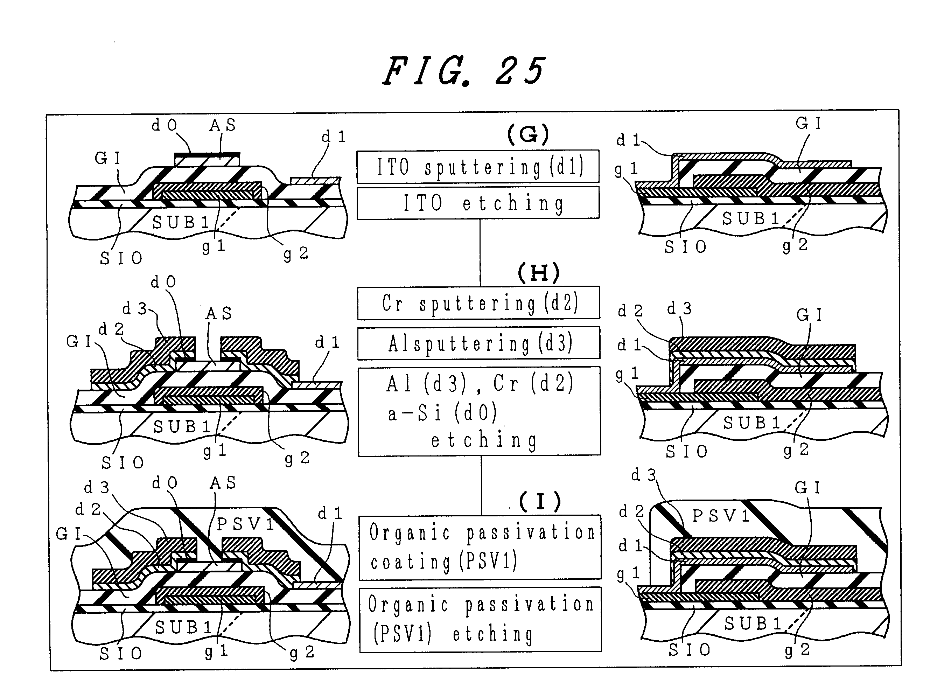

Step F, Fig. 25

A first conductive film d1 of ITO film with a thickness of 1400 Å is deposited by sputtering. The first conductive film d1 is selectively removed by an excimer laser with a wavelength of 248 nm and an energy density of 1 J/cm$^2$ to form gate terminals GTM, the uppermost layer of drain terminals DTM and transparent pixel electrodes ITO1.

### Step G, Fig. 25

A second conductive film d2 of Cr is deposited to a thickness of 600 Å by sputtering. Further, a third conductive film d3 of Cu 1000 Å thick or of Al-Pd, Al-Si, Al-Si-Ti, Al-Si-Cu, etc. 2000 Å thick is deposited by sputtering. An excimer laser with a wavelength of 193 or 248 nm and an energy density of 0.8 J/cm$^2$ is used to selectively remove the third conductive layer d3 and the second conductive layer d2 to form video signal lines DL, source electrodes SD1, and drain electrodes SD2 while at the same time selectively removing N(+) type semiconductor layer d0 between the exposed source and drain.

### Step H, Fig. 25

A PI organic transparent passivation film is coated by spinner to a thickness of 1 $\mu$m. An excimer laser having a wavelength of 308 nm and an energy density of 0.1 J/cm$^2$ is used to selectively remove the organic passivation film thereby forming a passivation film PSV1.

### Embodiment 3

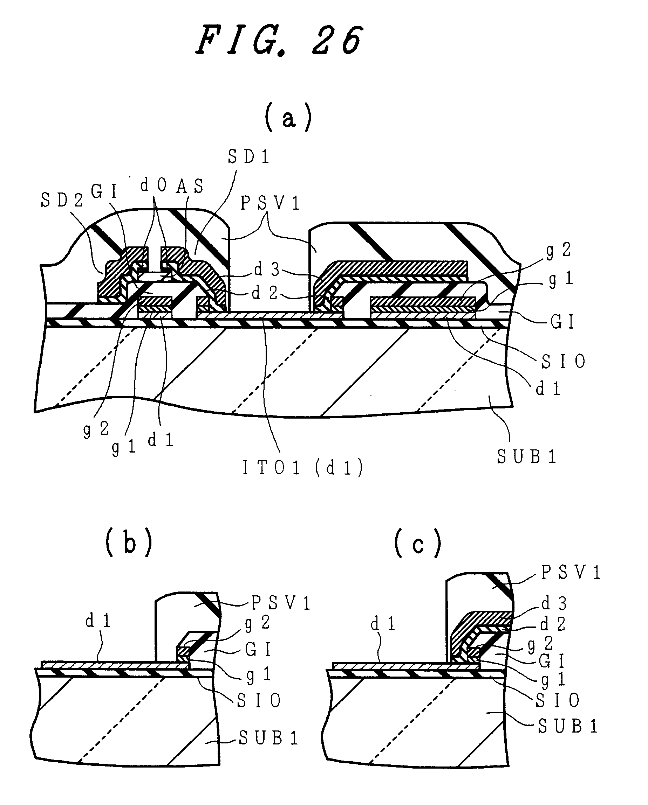

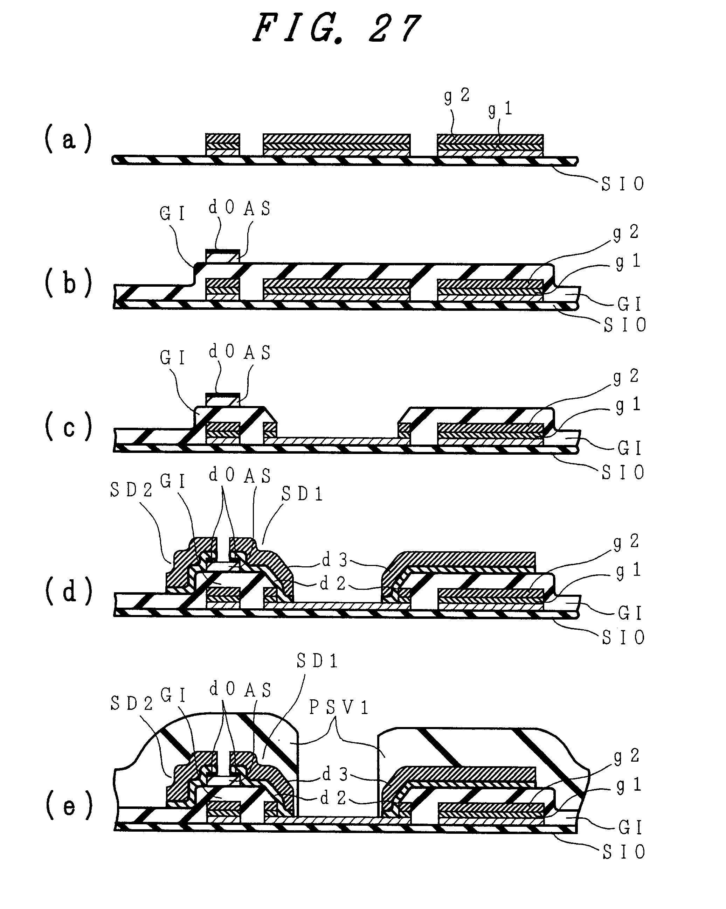

Figure 26 shows cross sections of a TFT substrate according to a further embodiment of this invention with a configuration different from the preceding embodiments. The cross sections represent the state in which the passivation film PSV1 is patterned. In the figure, (a) illustrates the cross section of a pixel portion, (b) the cross section of a gate terminal portion, and (c) the cross section of a signal line terminal portion. Figure 27 shows cross sections representing the fabrication flow involving a series of steps of patterning process for the pixel portion (a). What differs greatly from the preceding embodiments is that the gate electrode GT of double layer g1, g2 is formed after the layer d1 of the transparent pixel electrode ITO1 is deposited, thus eliminating the mask pattern dedicated for the layer d1 of the transparent pixel electrode ITO1. The process of manufacturing the TFT substrate of this embodiment will be described centering on the patterning process.

A glass substrate SUB1 1.1 mm thick with its surface polished is used for the transparent insulating substrate. A total of five patterning masks are prepared for the corresponding (a) to (e).

The step (a) deposits on the glass substrate a transparent electrode layer d1, a gate first conductive film g1 of Cr (or Ta, Mo, W), and a gate second conductive film g2 of Al, in that order. These films, from bottom to top, are 120 nm, 60 nm and 180 nm thick, respectively. These three layers are processed by a single photomask. The excimer laser technology is used for patterning these layers. The laser has a wavelength of 248 nm, an energy density of 3 J/cm$^2$ and a radiation area of 1 cm$^2$ per shot. The reason for using the excimer laser is its ability to easily process multiple layers of various metal materials simultaneously. In this embodiment, a good fabrication result was obtained with only 1 or two shots of laser. The TFT substrate corresponds to a 10-inch type display and the pattern area including the terminal section measures approximately 410 cm$^2$. The laser shot frequency is 100 Hz and hence the total beam irradiation time is 4.1 seconds. The process time is determined by the speed of the X-Y stage. In this embodiment the time it takes the X-Y stage to complete its stroke once is 1 second, and the process time is about 7 minutes. The subsequent steps employ the conventional photolithography.

The step (b) continuously deposits by CVD a silicon nitride gate insulating film GI, an amorphous silicon layer AS, and (n+) type amorphous silicon layer do, in that order. The (n+) type amorphous silicon layer d0 and the amorphous silicon layer AS are subjected to the photo processing for patterning.

The step (c) selectively etches away the gate insulating film GI, the gate second conductive film g2 and the gate first conductive film g1, in that order, by the photo processing using a single photomask.

The step (d) deposits a source-drain electrode layer d2 of Cr and a source-drain electrode layer d3 of Al in that order. The photo processing using a single photomask selectively etches away the source-drain electrode layer d3, the source-drain electrode layer d2 and the (n+) type amorphous silicon layer d0, in that order.

The step (e) deposits a silicon nitride passivation film PSV1 by the CVD method, which is then patterned by photo processing.

### Embodiment 4

What differs from the third embodiment is that the passivation film PSV1 at step (e) uses a transparent epoxy resin or acrylic resin and the patterning is done by using an excimer laser. The laser has a wavelength of 308 nm and an energy density of 0.3 J/cm$^2$. The film thickness is about 1 $\mu$m and the number of times the laser beam is emitted is 2 to 3 shots. Under this condition, the passivation film was processed without damaging the underlying films.

Embodiment 5

The point in which this embodiment differs from the fourth embodiment is that the excimer laser is used also at step (d). The laser has a wavelength of 248 nm and an energy density of 1 J/cm$^2$. The number of laser shots is 3 to 4 shots. Under this condition, a good pattern of film was obtained without damaging the underlying films.

Embodiment 6

In the fifth embodiment the photo processing at the remaining steps (b) and (c) is replaced with the excimer laser processing so that the excimer laser is used in all five patterning processes. At step (b) an excimer laser with a wavelength of 193 nm and an energy density of 1 J/cm$^2$ is used for selective removal of the (n+) type amorphous silicon layer d0 and the amorphous silicon layer AS$^2$. At step (c), the insulating film and the metal film were precessed by using 8 to 10 shots of a laser beam, 248 nm in wavelength and 0.2 J/cm$^2$ in energy density. A good processed pattern was obtained without causing any damage to the underlying layers.

Advantages of the Invention

With the embodiments of this invention, it is possible to significantly reduce the cost of manufacturing facilities required for pattern formation on the TFT substrate. In addition, the facilities incorporating the new technology are compact in size and only a fewer number of them are required, which in turn results in substantial reduction in the number of clean rooms and associated facilities and in electric power consumed by these facilities. Furthermore, since this invention does not use materials such as resist, the material cost will decrease, preventing environmental pollution associated with these processing. It is also possible to achieve a high yield and a high throughput for the entire fabrication process.

## Claims

1. Process for producing thin-film transistors and active matrix type LC displays, comprising the steps of:
   depositing a thin-film layer on an insulating substrate; selectively removing the thin-film layer;
   repeating the above steps to form in laminated layers a plurality of thin-film layers having desired patterns;
   and
   selectively removing at least one of the thin-film layers according to a mask pattern by means of an excimer laser.

2. The process according to claim 1, wherein products formed by the laser beam irradiation are removed by a gas and its flow to clean the processed portions.

3. The process according to claim 1 or 2, wherein a repetitive pattern is formed on the insulating substrate by moving an X-Y stage of an excimer laser fabrication facility on which the insulating substrate is mounted and by using an excimer laser optical system which permits a mask pattern to be inserted in the light path and which is so set as to form a pattern of the mask on the insulating substrate.

4. The process according to one or several of claims 1 to 3, characterized by the following subsequent steps:
   (A)
      (a) Providing a transparent insulating lower substrate (8);
      (b) depositing an insulating layer (SIO) on both sides of the lower substrate (8);
      (c) depositing a first electrically conductive thin film (g1) on the insulating layer (SIO);
      (d) selectively irradiating the electrically conductive thin film (g1) by means of an excimer laser (1),
   (B)
      (a) depositing an Al-based second electrically conductive thin film (g2) on the arrangement obtained in stage A;
      (b) photolithographic treatment of the thin film (g2);
      (c) selectively etching the thin film (g2), to produce an anodization mask;
   (C)
      (a) photolithographic treatment;
      (b) anodizing treatment to produce an Al$_2$O$_3$ film (AOF);
   (D)
      (a) depositing an Si nitride film;
      (b) depositing an i-type amorphous Si film;
      (c) depositing an N(+)-type amorphous Si film;
   (E) selectively irradiating by means of an excimer laser to selectively remove N(+)-type amorphous Si film and i-type amorphous Si film to form isolated islands of an i-type semiconductor layer;
   (F)
      (a) photolithographic treatment;
      (b) selectively etching the Si nitride film;

(G)

(a) depositing a first electrically conductive film (d1);

(b) selectively removing the first electrically conductive film (d1) by means of an excimer laser, to form gate terminals (GTM), the uppermost layer of drain terminals (DTM), and transparent pixel electrodes (ITO1);

(H)

(a) depositing a second electrically conductive film (d2);

(b) depositing a third electrically conductive film (d3);

(c) selectively removing the third electrically conductive film (d3) and the second electrically conductive film (d2) by means of an excimer laser, to form video signal lines (DL), source electrodes (SD1) and drain electrodes (SD2), while at the same time selectively removing the N-(+)-type semiconductor layer (dO) between the exposed source and drain;

(I)

(a) depositing an transparent passivation film (PSV1)

(b) selectively removing the passivation film by means of an excimer laser to form a patterned passivation film (PSV1) (Figs. 13 to 15).

5. The process according to claim 4, characterized by one or several of the following features.

(i) In stage A, step (a), a lower substrate (8) made of glass is used;

(ii) in stage A, step (b), the insulating layer (SIO) is made of SiO;

(iii) in stage A, step (c), the first electrically conductive film (g1) is made of Cr, preferably by means of sputtering, preferably to a thickness of about 1100 Å;

(iv) in stage A, step (d), an excimer laser having a wavelength of 248 nm and an energy density of about 0.3 $J/cm^2$ is used;

(v) in stage B, step (a), the second electrically conductive thin film (g2) is made of Al, Al-Pd, Al-Si, Al-Si-Ti or Al-Si-Cu, preferably by means of sputtering;

(vi) in stage B, step (c), the selective etching is carried out using a mixed acid solution comprising phosphoric acid, nitric acid and glacial acetic acid;

(vii) in stage C, step (b), the anodization is carried out using an anodizing solution comprising tartaric acid and ethylene glycol;

(viii) in stage D, step (a), an Si nitride film of a thickness of about 2000 Å is produced;

(ix) in stage D, step (b), an amorphous Si film of a thickness of about 2000 Å is produced;

(x) in stage D, step (c), an amorphous Si film of a thickness of about 300 Å is produced;

(xi) in stage E, an excimer laser having a wavelength of 248 nm and an energy density of about 2 $J/cm^2$ is used;

(xii) in stage F, step (b), the etching of the Si nitride film is made by dry etching using $SF_6$;

(xiii) in stage G, step (a), the first electrically conductive film (d1) is made of an ITO film, preferably by means of sputtering, preferably to a thickness of about 1400 Å;

(xiv) in stage G, step (b), an excimer laser having a wavelength of 248 nm and an energy density of about 1 $J/cm^2$ is used;

(xv) in stage H, step (a), the second electrically conductive film (d2) is made of Cr, preferably by means of sputtering, preferably to a thickness of about 600 Å;

(xvi) in stage H, step (b), the third electrically conductive film (d3) is made of Al-Pd, Al-Si, Al-Si-Ti or Al-Si-Cu, preferably by means of sputtering, preferably to a thickness of about 2000 Å;

(xvii) in stage H, step (c), the selective removal of the electrically conductive films (d3 and d2) is carried out using an excimer laser having a wavelength of 193 or 248 nm and an energy density of about 0.8 $J/cm^2$;

(xviii) in stage I, step (a), the passivation film (PSV1) is made of an organic material, preferably having a thickness of about 1 $\mu$m;

(xix) in stage I, step (b), the selective removal of the passivation film (PSV1) is carried out using an excimer laser having a wavelength of 308 nm and an energy density of about 0.1 $J/cm^2$.

6. Apparatus for carrying out the process of claims 1 to 5, particularly the selective layer removal steps, comprising:

- an excimer laser (1),
- an image forming system (5, 7) projecting a mask (6) onto a substrate (8),
- an X-Y stage (9) for carrying the substrate (8),
- means (17) for controlling the X-Y stage (9) according to a predetermined program.

7. The apparatus according to claim 6, characterized in that the mask (6) comprises at least a number of patterns that corresponds to an integer times the vertical and horizontal repetition cycles of the total substrate pattern, and the means (17) for controlling the X-Y stage (9) are designed such that the entire pattern on the substrate is formed by corresponding movement steps of the X-Y stage (9).

8. The apparatus according to claim 6 and/or 7, characterized in that it is provided with a mechanism for changing the mask (6).

9. The apparatus according to one or several of claims 6 to 8, characterized in that it comprises means for removing the decomposition material dispersed by the excimer laser beam via a gas flow, preferably means for laminar gas flow, or a nozzle for blowing away the decomposition material.

10. The apparatus according to claim 9, characterized by a shield plate (10) which has at least one opening (18) through which the beam of the excimer laser (1) may pass, is arranged at a small distance from the surface of the substrate to be irratiated to define a channel (19) through which a flow (12) of a purging gas may be led over the surface, and which is connected at one end portion with a high pressure input gas source and at a second end portion with an outlet port, preferably connected with a sucking device, the arrangement of the shield plate (10) and the design of the gas source and of the outlet port being such that a gas flow (12) is produced at the irradiation site the speed of which is preferably higher than that of the expansion of the decomposition debris (11) (Fig. 22(A).

11. The apparatus according to claim 9, characterized by a nozzle (13) connected to a purging gas source and having its opening provided in the vicinity of the irradiated surface portion and at a small distance therefrom, for blowing a gas flow (12) over the surface, and a shield plate (20) arranged at a small distance from the surface of the area to be treated and being connected to an outlet port, and preferably also to a sucking device, the shield plate (20) preferably being disposed such that it is inclined with respect to the substrate surface, the lower edge being in the vicinity of the irradiated area, and the gas source being designed such that the gas flow (12) is intermittent and/or a shock flow (Fig. 22(B)).

12. The apparatus according to one or several of claims 6 to 11, characterized in that it comprises shutter means for determining the exposure time.

13. The apparatus according to one or several of claims 6 to 12, characterized in that the excimer laser (1) is a gas laser based on $F_2$ (157 nm), ArF (193 nm), KrCl (222 nm), KrF (248 nm), XeCl (308 nm) or XeF (351 nm).

14. Thin-film transistors and active matrix LC displays, obtainable according to the process of claims 1 to 5.

FIG. 1

# FIG. 2

# FIG. 3

FIL (R)     BM  ITO2 (COM)  FIL (G)

POL2
SIO
SUB2

SIO
PSV2
LC
ORI2
ORI1
TFT1    d0
PSV1
GI
SIO
SD2 { d3 / d2    AOF  GT, g2  AS  d3 / d2 } SD1  d0
SUB1
SIO
ITO1, d1  POL1

# FIG. 4

# FIG. 5

EP 0 616 241 A2

## FIG. 6

SUB2 Td (e)  PNL
SUB1
ITO2 (COM)
Tg
AR SL INJ
LN
BM
Td (o)

EP 0 616 241 A2

# FIG. 7

PRT

SHd      DM1

DMd

DTM

Td (ө)

DT1

CT1   CT2   PSV1   BM   DT0

INT

SUB1    8a

SUB2

AGP

SHg   8a

LN

ITO2 (COM)

PSV1

ITO2 (COM)

Tg   GI

GTM    GT0   SL   BM

DM2   DMg   GT1     AR

EP 0 616 241 A2

# FIG. 8

(a)     (b)     (c)

FIL (R)     ITO2 (COM)

POL2   SIO     BM     FIL (G)

POL2
SIO
SUB2

SIO     BM

PSV2     SIO     BM

ITO2 (COM)     SIO
BM
PSV2

SL     LC
PSV1     TFT1     d0     ORI2     ORI1

PSV1   AGP     PSV1

SL
DTM
d3     d1
g1

SIO     d3
SD2{ d2     AS     d3}SD1
GT,g2     AOF{ d2

PSV1
GI
SIO     d2

SUB1     g1     d1     GT,g2     AOF{d2
SIO     INT

SUB1
SIO

POL1     ITO1,d1     POL1

EP 0 616 241 A2

# FIG. 9

EP 0 616 241 A2

# FIG. 10 (A)

# FIG. 10 (B)

EP 0 616 241 A2

# FIG. 11 (A)

DL (d2, d3)

TSTd

B

AS

DTM

d2, d3

d1

B

GI

PSV1

g1

AO

# FIG. 11 (B)

d0

PSV1

d3 d2

AS

DTM

d1

GI

g1

SUB1

SIO

POL1

# FIG. 12

# FIG. 13

EP 0 616 241 A2

**(A)**

| Cr sputtering (g1) |
|---|
| Cr etching |

**(B)**

| Al sputtering (g2) |
|---|
| 1st photo (for Al) |
| Al etching (g2) |

**(C)**

| 2nd photo (for AO) |
|---|
| Anodizing |

# FIG. 14

(D)

| C V D | SiN (GI) |
| | a-Si (AS) |
| | N Type a-Si (d0) |

(E)

a-Si (d0, AS)
etching

(F)

3rd photo (for GI)

SiN etching (GI)

EP 0 616 241 A2

# FIG. 15

**(G)**

| ITO sputtering (d1) |
|---|
| ITO etching |

**(H)**

| Cr sputtering (d2) |
|---|
| Alsputtering (d3) |
| Al (d3), Cr (d2)<br>a−Si (d0)<br>etching |

**(I)**

| Organic passivation<br>coating (PSV1) |
|---|
| Organic passivation<br>(PSV1) etching |

EP 0 616 241 A2

# FIG. 16

# FIG. 17

# FIG. 18

# FIG. 19

# FIG. 20

# FIG. 21

# FIG. 22 (A)

# FIG. 22 (B)

# FIG. 23

(A)

| Cr sputtering (g1) |
|---|
| Cr etching |

(B)

| Cu sputtering (g2) |
|---|
| Cu etching |

EP 0 616 241 A2

# FIG. 24

(D)

| C V D | SiN (GI) |
| | a−Si (AS) |
| | N Type a−Si (d0) |

(E)

a−Si (d0, AS) etching

(F)

3rd photo (for GI)

SiN etching (GI)

EP 0 616 241 A2

# FIG. 25

# FIG. 26

## (a)

SD1
SD2 GI d0 AS
PSV1
g2
g1
GI
d3
d2
SIO
d1
g2
g1 d1
ITO1 (d1)
SUB1

## (b)

PSV1
d1
g2
GI
g1
SIO
SUB1

## (c)

PSV1
d1
d3
d2
g2
GI
g1
SIO
SUB1

# FIG. 27

(a)

g 2    g 1

S I O

(b)

GI  d0 A S

g 2
g 1
GI
S I O

(c)

GI  d0 A S

g 2
g 1
GI
S I O

(d)

S D2 GI  d0 A S  S D1

d 3
d 2
g 2
g 1
GI
S I O

(e)

S D1
S D2 GI  d0 A S  P S V 1

d 3
d 2
g 2
g 1
GI
S I O